# EUROPÄISCHE PATENTSCHRIFT

(11) **EP 2 149 160 B1**
(45) Veröffentlichungstag und Bekanntmachung des Hinweises auf die Patenterteilung: **04.01.2017**
(21) Anmeldenummer: 08748777.3
(22) Anmeldetag: 25.04.2008
(51) Int. Cl.: H01L 33/38, H01L 33/46, H01L 33/20, H01L 33/50

(54) **OPTOELEKTRONISCHES BAUELEMENT UND VERFAHREN ZUR HERSTELLUNG EINER MEHRZAHL OPTOELEKTRONISCHER BAUELEMENTE**
OPTOELECTRONIC COMPONENT AND METHOD FOR PRODUCING A PLURALITY OF OPTOELECTRONIC COMPONENTS
COMPOSANT OPTOÉLECTRONIQUE ET PROCÉDÉ DE FABRICATION D'UNE PLURALITÉ DE COMPOSANTS OPTOÉLECTRONIQUES

(30) Priorität: 26.04.2007 DE 102007019776
(43) Veröffentlichungstag der Anmeldung: 03.02.2010
(73) Patentinhaber: OSRAM Opto Semiconductors GmbH, 93055 Regensburg (DE)
(72) Erfinder: ILLEK, Stefan, 93093 Donaustauf (DE); PLOESSL, Andreas, 93051 Regensburg (DE); HEINDL, Alexander, 93326 Abensberg (DE); RODE, Patrick, 93051 Regensburg (DE); EISSLER, Dieter, 93152 Nittendorf/Etterzhausen (DE)
(74) Vertreter: Epping - Hermann - Fischer
(86) Internationale Anmeldenummer: PCT/DE2008/000704
(87) Internationale Veröffentlichungsnummer: WO 2008/131736

(56) Entgegenhaltungen:
- EP-A- 0 977 277
- EP-A- 1 367 656
- EP-A- 1 569 283
- WO-A1-2005/081319
- JP-A- 57 092 881
- US-A1- 2003 015 713
- US-A1- 2003 151 058
- US-A1- 2006 108 593

## Beschreibung

Die vorliegende Erfindung betrifft ein optoelektronisches Bauelement, insbesondere ein zur Strahlungserzeugung geeignetes optoelektronisches Bauelement, und ein Verfahren zur Herstellung einer Mehrzahl solcher Bauelemente.

Seitlich emittierende optoelektronische Bauelemente jeweils mit einer verspiegelten Seitenfläche sind beispielsweise aus der EP 1 367 656 A (TOYODA GOSEI KK [JP]; 3. Dezember 2003) und der US 2003/151058 A1 (UEMURA TOSHIYA [JP] ET AL; 14. August 2003) bekannt.

Die WO 2005/081319 A1 (OSRAM OPTO SEMICONDUCTORS GMBH [DE]; WIRTH RALF [DE]; BRUNNER HERBERT; 1. September 2005) offenbart ein lichtemittierendes Halbleiterbauelement, bei dem Kontakte unterschiedlicher Polarität auf einer gemeinsamen Anschlussseite angeordnet sind und in der Draufsicht auf die Anschlusseite überlappen.

Eine Aufgabe der vorliegenden Erfindung ist es, ein optoelektronisches Bauelement mit hoher spezifischer Ausstrahlung anzugeben, das vereinfacht herstellbar ist. Ferner soll ein kostengünstiges Herstellungsverfahren für die Herstellung derartiger Bauelemente angegeben werden. Die spezifische Ausstrahlung ist dabei die im Betrieb des Bauelements von dem Bauelement ausgesandte Strahlungsleistung in W pro m² der Auskoppelfläche des Bauelements, durch die Strahlung mit dieser Strahlungsleistung hindurch tritt. Diese Aufgabe wird durch ein Bauelement und ein Herstellungsverfahren gemäß den unabhängigen Patentansprüchen 1 und 7 gelöst, die die vorliegende Erfindung definieren. Vorteilhafte Ausgestaltungen und Weiterbildungen sind Gegenstand der abhängigen Patentansprüche.

Ein erfindungsgemäßes optoelektronisches Bauelement umfasst einen Halbleiterkörper, der einen zur Strahlungserzeugung geeigneten aktiven Bereich aufweist, und zumindest zwei auf dem Halbleiterkörper angeordnete elektrische Kontakte. Dabei sind die Kontakte elektrisch leitend mit dem aktiven Bereich verbunden und weisen jeweils eine vom Halbleiterkörper abgewandte Anschlussfläche auf. Die Anschlussflächen sind auf einer gemeinsamen Anschlussseite des Bauelements angeordnet und eine von der Anschlussseite verschiedene Seite des Bauelements ist verspiegelt.

Bevorzugt weist der Halbleiterkörper eine Halbleiterschichtenfolge auf, die den aktiven Bereich umfasst. Die Halbleiterschichtenfolge kann den Halbleiterkörper bilden und insbesondere epitaktisch gewachsen sein.

Die verspiegelte Seite des Bauelements ist zweckmäßigerweise für die im aktiven Bereich zu erzeugende Strahlung reflektierend ausgebildet. Auf die verspiegelte Seite des Bauelements treffende Strahlung wird aufgrund der Verspiegelung in das Bauelement zurück reflektiert. Mittels der Verspiegelung kann Strahlung, die bei fehlender Verspiegelung auf dieser Seite aus dem Bauelement austreten würde, zu einer oder einer Mehrzahl von Auskoppelflächen des Bauelements gelenkt werden. Strahlungsaustritt aus dem Bauelement auf der verspiegelten Seite wird folglich vermindert oder vollständig vermieden. Damit wird die über die Auskoppelfläche(n) ausgekoppelte Strahlungsleistung und dementsprechend die spezifische Ausstrahlung seitens der Auskoppelfläche erhöht.

Eine Reflektivität der Verspiegelung für die in dem aktiven Bereich zu erzeugende Strahlung beträgt bevorzugt 80 % oder mehr, besonders bevorzugt 90 % oder mehr, am meisten bevorzugt 95 % oder mehr, z.B. 96 % oder mehr. Zweckmäßigerweise ist die verspiegelte Seite des Bauelements für die Verspiegelung mit einer Spiegelschicht versehen. Die Spiegelschicht ist vorzugsweise auf dem Bauelement abgeschieden, z. B. mittels eines PVD- oder CVD-Verfahrens (PVD: Physical Vapor Deposition; CVD: Chemical Vapor Deposition), etwa über Sputtern, Aufdampfen oder reaktives Sputtern.

Weiterhin ist das Bauelement bevorzugt aussenseitig verspiegelt. Beispielsweise ist hierzu eine das Bauelement in einer lateralen Haupterstreckungsrichtung des aktiven Bereichs begrenzende Seitenfläche des Bauelements verspiegelt.

In einer bevorzugten Ausgestaltung weist die Spiegelschicht eine Spiegelmetallisierung oder eine Spiegellegierung auf, welche wiederum vorzugsweise mindestens ein Metall enthält. Die Spiegelschicht kann insbesondere elektrisch leitfähig ausgebildet sein. Beispielsweise enthält die Spiegelschicht Ag, Al oder Au. Die Spiegelschicht kann insbesondere als Spiegelmetallisierung, z.B. mit einem der genannten Metalle, oder als Legierungsschicht, z.B. mit mindestens einem der genannten Metalle, ausgebildet sein. Metalle oder Legierungen zeigen hohe Reflektivitäten über einen breiten Spektralbereich, oftmals aber auch im Wärmestrahlungs-Spektralbereich.

Alternativ oder ergänzend zu einer elektrisch leitfähigen Spiegelschicht - wie etwa einer elektrisch leitfähigen Spiegelmetallisierung oder einer elektrisch leitfähigen Spiegellegierung - kann die Verspiegelung, insbesondere die Spiegelschicht, einen Kaltlichtspiegel aufweisen. Zweckmäßigerweise ist der Kaltlichtspiegel derart ausgeführt, dass er die im aktiven Bereich erzeugte Strahlung reflektiert, im Bauelement bei der Strahlungserzeugung anfallende Verlustwärme jedoch transmittiert. Die Gefahr einer thermisch bedingten Schädigung des Bauelements aufgrund zu hoher interner Temperaturen im Bauelement wird dadurch verringert.

In einer bevorzugten Ausgestaltung umfasst die Verspiegelung und insbesondere die Spiegelschicht eine dielektrische Spiegelschicht. Auf aufwendige Isolationsmaßnahmen zur Isolation der Spiegelschicht von elektrisch leitfähigen Elementen des Bauelements, um einen Kurzschluss zu vermeiden, kann bei einer dielektrischen Spiegelschicht verzichtet werden. Eine dielektrische Spiegelschicht kann als Mehrschichtstruktur, welche dielektrische Schichten mit unterschiedlichen Brechungsindices umfasst, ausgebildet sein. Der Kaltlichtspiegel kann insbesondere als dielektrische Mehrschichtstruktur ausgeführt sein.

In einer weiteren bevorzugten Ausgestaltung weist die Verspiegelung und insbesondere die Spiegelschicht eine dielektrische Spiegelschicht und eine elektrisch leitfähige Spiegelschicht auf. Eine dielektrische Spiegelschicht, z.B. der Kaltlichtspiegel, kann also auch in Kombination mit einer elektrisch leitfähigen Spiegelschicht, z. B. einer Spiegelmetallisierung oder Spiegellegierung der weiter oben beschriebenen Art, eingesetzt werden. In diesem Fall ist die elektrisch leitfähige Spiegelschicht zweckmäßigerweise auf der vom Bauelement abgewandten Seite der dielektrischen Spiegelschicht angeordnet. Im aktiven Bereich erzeugte Strahlung trifft dann zunächst auf den dielektrischen Spiegel und kann dort bereits teilreflektiert werden. Ein durch die dielektrische Spiegelschicht hindurch tretender Strahlungsanteil kann an der elektrisch leitfähigen Spiegelschicht reflektiert werden. Sowohl die dielektrische Spiegelschicht als auch die elektrisch leitfähige Spiegelschicht tragen somit zur Gesamtreflektivität der Verspiegelung bei. Für eine Spiegelmetallisierung oder - legierung können daher gegebenenfalls Materialien mit vergleichsweise geringer Reflektivität, z. B. von 80 % oder weniger und vorzugsweise 70 % oder mehr eingesetzt werden. Durch das Vorsehen einer dielektrischen Spiegelschicht kann eine Steigerung der Gesamtreflektivität der Verspiegelung, die die dielektrische Spiegelschicht und die elektrisch leitfähige Spiegelschicht umfasst, erzielt werden.

Bevorzugt ist das Bauelement als Lumineszenzdiode, besonders bevorzugt zur Erzeugung und insbesondere zur Auskopplung inkohärenter Strahlung ausgebildet. Ferner ist das Bauelement bevorzugt zur Erzeugung sichtbarer Strahlung ausgebildet.

Über die Anschlussflächen der Kontakte kann das Bauelement von der Anschlussseite her extern elektrisch kontäktiert werden. Das Vorsehen elektrischer Kontakte auf anderen Seiten des Bauelements kann dadurch vermieden werden. Elektrische Kontakte für optoelektronische Bauelemente, z. B. Kontaktmetallisierungen oder legierungsbasierte Kontakte, absorbieren meist nicht unerheblich die im aktiven Bereich erzeugte Strahlung. Da vorliegend beide Anschlussflächen auf der gleichen Seite des Bauelements angeordnet sind, kann grundsätzlich über eine beliebige andere Seite des Bauelements Strahlung ausgekoppelt werden, ohne dass auf dieser Seite ein Kontakt vorgesehen ist. Eine Absorption in einem Kontakt seitens der Auskoppelseite wird so vermieden. Abgesehen von der Anschlussseite können die verbleibenden Aussenseiten des noch unverspiegelten Bauelements frei von eine Auskopplung behindernden, absorbierenden Strukturen, etwa absorbierenden Metallen, sein. Über die zusätzliche reflektierende Verspiegelung kann die auskoppelseitige spezifische Ausstrahlung erhöht werden.

Die Auskoppelfläche ist zweckmäßigerweise unverspiegelt.

Weiterhin erleichtert das Vorsehen von zwei Kontakten auf der gemeinsamen Anschlussseite des optoelektronischen Bauelements das kostengünstige Fertigen derartiger Bauelemente im Verbund.

In einer bevorzugten Ausgestaltung ist die Anschlussseite des Bauelements die Montageseite des Bauelements. Als Montageseite des Bauelements ist dabei die Seite des Bauelements anzusehen, die bei der Montage des Bauelements auf einem externen Anschlussträger, vorzugsweise einem flächigen Anschlussträger, z. B. einer Leiterplatte, dem Anschlussträger zugewandt ist. Die Kontakte des Bauelements können mit Anschlussleitern des Anschlussträgers elektrisch leitend verbunden werden, sodass dem aktiven Bereich für den Betrieb des Bauelements externe elektrische Leistung zugeführt werden kann. Die leitende Verbindung kann durch eine elektrisch leitende Verbindungsschicht hergestellt sein. Auf einen Bondddraht, mit einem aufgrund des Drahtbogens hohen Platzbedarf, kann zur Kontaktierung des Bauelements verzichtet werden.

Die Anschlussflächen der Kontakte des Bauelements sind vorzugsweise zur elektrisch leitenden Verbindung mit Anschlussleitern eines Anschlussträgers mittels einer elektrisch leitenden Schichtverbindung ausgebildet. Zum Beispiel sind die Anschlussflächen jeweils mittels eines Lots gebildet.

Das Bauelement kann als oberflächenmontierbares Bauelement (SMD: Surface Mountable Device) ausgebildet sein.

In einem erfindungsgemäßen Verfahren zur Herstellung einer Mehrzahl von optoelektronischen Bauelementen wird zunächst ein Verbundelement mit einer Trägerschicht und einer Mehrzahl von, vorzugsweise nebeneinander, auf der Trägerschicht angeordneten Halbleiterkörpern, die jeweils einen zur Strahlungserzeugung geeigneten aktiven Bereich aufweisen, bereitgestellt.

Daraufhin wird eine Spiegelschicht auf das Verbundelement aufgebracht. Die Spiegelschicht kann insbesondere auf das Verbundelement abgeschieden werden. Hierzu eignen sich beispielsweise die oben erwähnten PVD- oder CVD-Verfahren.

Die Halbleiterkörper sind vorzugsweise als diskrete Halbleiterkörper, die voneinander beabstandet auf der gemeinsamen Trägerschicht angeordnet sind, ausgeführt.

Das Verbundelement wird nach dem Aufbringen der Spiegelschicht in eine Mehrzahl optoelektronischer Bauelemente vereinzelt, wobei die Bauelemente jeweils eine Auskoppelfläche und eine das Bauelement begrenzende, von der Auskoppelfläche verschiedene und mit der Spiegelschicht versehene verspiegelte Seitenfläche aufweisen.

Die verspiegelte Seitenfläche begrenzt das Bauelement vorzugsweise in lateraler Richtung, insbesondere in Erstreckungsrichtung des aktiven Bereichs. Die Seitenfläche kann sich von der Anschlussseite des Bauelements weg in Richtung und vorzugsweise bis zu einer von der Anschlussseite abgewandten Seite des Bauelements erstrecken.

Die auf das Verbundelement aufgebrachte Spiegelschicht und/oder die Trägerschicht wird beim Vereinzeln vorzugsweise durchtrennt. Die aus dem Verbundelement vereinzelten Bauelemente können demnach jeweils mit einem Teil der auf das Verbundelement aufgebrachten Spiegelschicht versehen sein. Bauelemente mit einer verspiegelten Seitenfläche können also im Verbund hergestellt werden, was eine kostengünstige Herstellung einer Mehrzahl gleichartiger Bauelemente erleichtert.

Das erfindungsgemäße Herstellungsverfahren wird zur Herstellung erfindungsgemäßer optoelektronischer Bauelemente eingesetzt, so dass oben und im Folgenden für das Bauelement beschriebene Merkmale auch für das Herstellungsverfahren herangezogen werden können, und umgekehrt.

Die Halbleiterkörper eines Verbundelements sind vorzugsweise gleichartig, insbesondere mit der gleichen Abfolge an gleich zusammengesetzten Halbleiterschichten ausgebildet.

Die Auskoppelfläche des Bauelements kann eine vereinzelte, also beim Vereinzeln ausgebildete, Auskoppelfläche sein. Die Auskoppelfläche begrenzt das Bauelement in diesem Fall bevorzugt lateral.

In einer bevorzugten Ausgestaltung werden die elektrischen Kontakte für die elektrische Kontaktierung der Halbleiterkörper der herzustellenden Bauelemente vor dem Aufbringen der Spiegelschicht vorgesehen. Dabei sind einem

Halbleiterkörper des Verbundelements bevorzugt jeweils zwei Kontakte zugeordnet, die auf einer Seite des Halbleiterkörpers - insbesondere auf der gleichen Seite des Halbleiterkörpers, vorzugsweise der Anschlussseite des späteren Bauelements - angeordnet sind. Die Kontakte sind bevorzugt mit dem aktiven Bereich des (dem jeweiligen Kontakt zugeordneten) Halbleiterkörpers elektrisch leitend verbunden. Weiterhin sind die Kontakte zweckmäßigerweise zumindest teilweise auf der gleichen Fläche des Halbleiterkörpers, insbesondere auf der der Trägerschicht abgewandten Seite des aktiven Bereichs, angeordnet.

Eine derartige Anordnung der Kontakte auf einer Seite des Halbleiterkörpers vereinfacht die Herstellung einer Mehrzahl von Bauelementen im Verbund.

In einer weiteren bevorzugten Ausgestaltung weist das Bauelement einen Träger auf, auf dem der Halbleiterkörper angeordnet ist. Ein epitaktisch gewachsener Halbleiterkörper kann durch den Träger mechanisch stabilisiert werden. Die Gefahr einer Schädigung des Halbleiterkörpers wird so verringert. Der Träger kann beim Vereinzeln eines Verbundelements aus der beim Vereinzeln durchtrennten Trägerschicht hervorgehen.

Die Trägerschicht kann aus dem Aufwachssubstrat, auf dem eine Halbleiterschichtstruktur gewachsen wurde, aus der die Halbleiterkörper des Verbundelements ausgebildet sind, gebildet sein.

Der Träger kann jedoch auch vom Aufwachssubstrat verschieden sein. Nach dem Wachsen von Halbleiterschichten für den Halbleiterkörper auf dem Aufwachssubstrat kann dieses entfernt werden. Zweckmäßigerweise wird der Träger oder eine entsprechende Trägerschicht, aus der ein Träger vereinzelt wird, vor dem Entfernen des Aufwachssubstrates vorgesehen, um das Halbleitermaterial beim Entfernen mechanisch zu stabilisieren. Das Bauelement kann also frei von einem Aufwachssubstrat für die Halbleiterschichten des Halbleiterkörpers sein.

Alternativ kann jedoch auf einen den Halbleiterkörper stabilisierenden Träger verzichtet werden. Das Bauelement kann insbesondere aus epitaktisch gewachsenen Halbleiterschichten des Halbleiterkörpers, den Kontakten und gegebenenfalls weiteren auf den Halbleiterkörper aufgebrachten, vorzugsweise nicht freitragenden Schichten, bestehen. Die Kontakte und/oder die weiteren auf den Halbleiterkörper aufgebrachten Schichten können mittels Abscheiden auf den Halbleiterkörper aufgebracht sein. Beim Abscheiden wächst die Schichtdicke mit der Abscheidezeit.

Das Bauelement kann also als trägerloses Bauelement ausgeführt sein. Auf einen gesondert vorgesehenen, insbesondere freitragenden, Träger zur mechanischen Stabilisierung des Halbleiterkörpers kann verzichtet sein. Für ein trägerloses Bauelement kann beispielsweise das Aufwachssubstrat entfernt sein.

Da auf einen Träger verzichtet wird, kann eine sehr geringe Bauhöhe des Bauelements erreicht werden. Gegenüber Bauelementen mit Träger ist bei der Handhabung derartiger Bauelemente, wie z. B. der Montage, eine erhöhe Sorgfalt erforderlich, um eine Schädigung des Bauelements zu vermeiden.

In einer bevorzugten Ausgestaltung sind die Anschlussflächen der Kontakte auf einer gemeinsamen, vorzugsweise ebenen, Oberfläche des Halbleiterkörpers angeordnet. Die Anschlussflächen können sich insbesondere über diese Oberfläche erstrecken. Diese Oberfläche ist vorzugsweise zwischen dem aktiven Bereich und den Anschlussflächen der Kontakte angeordnet. Einer der Kontakte ist zweckmäßigerweise seitens dieser Oberfläche des Halbleiterkörpers, vorzugsweise unmittelbar, elektrisch leitend mit dem Halbleiterkörper verbunden. Der andere Kontakt ist dann zweckmäßigerweise auf der dieser Oberfläche abgewandten Seite des aktiven Bereichs elektrisch leitend mit dem Halbleiterkörper verbunden. Ferner sind die Anschlussflächen bevorzugt auf der dem Träger abgewandten Seite des aktiven Bereichs auf dem Halbleiterkörper angeordnet.

Die Kontakte sind weiterhin bevorzugt auf dem Halbleiterkörper aufgebracht, besonders bevorzugt abgeschieden. Beispielsweise können die Kontakte mittels eines PVD- oder CVD-Verfahrens - wie etwa Aufdampfen oder ein anderes der weiter oben genannten Verfahren - auf den Halbleiterkörper aufgebracht sein.

Erfindungsgemäß sind die Kontakte anschlussseitig elektrisch voneinander isoliert. Hierzu sind die Kontakte auf der Anschlussseite durch eine Isolationsschicht elektrisch voneinander getrennt.

Erfindungsgemäß erstreckt sich einer der Kontakte bereichsweise zwischen dem Halbleiterkörper und der Anschlussfläche des anderen Kontakts. Trotz einer Anordnung der beiden Anschlussflächen auf einer Seite des Halbleiterkörpers kann durch das Ausdehnen des einen Kontakts bis unterhalb der Anschlussfläche des anderen Kontakts eine über die laterale Erstreckungsrichtung des Halbleiterkörpers verteilte Ladungsträgerinjektion in den Halbleiterkörper erzielt werden.

In einer weiteren bevorzugten Ausgestaltung ist einer der Kontakte anschlussseitig mit dem Halbleiterkörper elektrisch leitend verbunden und der andere Kontakt ist auf der von der Anschlussseite des Bauelements abgewandten Seite des aktiven Bereichs elektrisch leitend mit dem Halbleiterkörper verbunden. Der letztgenannte Kontakt kann sich dazu von der Anschlussseite über den Bereich des aktiven Bereichs bis zu der der Anschlussseite abgewandten Seite des aktiven Bereichs erstrecken und auf dieser Seite elektrisch leitend mit dem Halbleiterkörper verbunden sein. Zweckmäßigerweise ist dieser Kontakt hierzu von der Anschlussseite bis zu der der Anschlussseite abgewandten Seite des aktiven Bereichs - beispielsweise über eine sich entlang des Halbleiterkörpers erstreckende Isolationsschicht - elektrisch von dem Halbleiterkörper isoliert. Ein Kurzschluss des Bauelements kann so vermieden werden.

Im Halbleiterkörper kann ein Durchbruch durch den aktiven Bereich ausgebildet sein, durch den sich der Kontakt von der einen Seite des aktiven Bereichs zur anderen Seite des aktiven Bereichs erstreckt. Der Durchbruch kann beispielsweise durch einen von der Anschlussseite aus in den Halbleiterkörper eindringenden und mit dem Kontaktmaterial befüllten ausgesparten Bereich des Halbleiterkörpers gebildet sein. Insbesondere kann eine Mehrzahl von Durchbrüchen durch den aktiven Bereich vorgesehen sein, durch die sich der Kontakt von der einen Seite des aktiven Bereichs zur anderen Seite des aktiven Bereichs hin erstrecken kann.

Alternativ oder ergänzend zum Vorsehen eines Durchbruchs kann sich der Kontakt auch neben einer den Halbleiterkörper lateral begrenzenden Seitenfläche von der Anschlussseite bis zu der der Anschlussseite abgewandten Seite des aktiven Bereichs erstrecken. Auf eine lokale Aussparung des Halbleiterkörpers kann in diesem Falle verzichtet werden. Beispielsweise kann der Kontakt hierzu zumindest bereichsweise rahmenartig ausgebildet sein. Auch hierbei ist der Kontakt vom aktiven Bereich - beispielsweise über eine sich entlang der Seitenfläche ersteckende Isolationsschicht - zweckmäßigerweise elektrisch isoliert, so dass ein Kurzschluss des Bauelements vermieden wird.

In einer weiteren bevorzugten Ausgestaltung weist einer der Kontakte eine Kontaktschicht auf. Diese Kontaktschicht ist mit Vorzug bereichsweise zwischen dem Halbleiterkörper und der Anschlussfläche des anderen Kontakts angeordnet. Vorzugsweise erstreckt sich die Kontaktschicht großflächig über den Halbleiterkörper. Die Kontaktschicht kann sich insbesondere von der Anschlussfläche des einen Kontakts bis zu und vorzugsweise unter die Anschlussfläche des anderen erstrecken. Über die Kontaktschicht kann der eine Kontakt großflächig elektrisch leitend mit dem Halbleiterkörper verbunden sein, so dass über diesen Kontakt eine großflächige und homogene Ladungsträgerinjektion in den Halbleiterkörper erzielt werden kann.

Die Kontaktschicht ist mit Vorzug, insbesondere lediglich, für den Durchtritt des anderen Kontakts durch die Kontaktschicht durchbrochen. Die Kontaktschicht kann also als durchgehende oder für den Durchtritt des anderen Kontakts durchbrochene Schicht ausgeführt sein. Zweckmäßigerweise ist die Kontaktschicht von dem anderen Kontakt hierzu elektrisch isoliert. Auf eine Aussparung der Kontaktschicht kann beispielsweise verzichtet werden, falls sich der andere Kontakt neben einer Seitenfläche des Halbleiterkörpers von der Anschlussseite bis zu der der Anschlussseite abgewandten Seite des aktiven Bereichs erstreckt.

In einer weiteren bevorzugten Ausgestaltung weist das Bauelement, insbesondere anschlussseitig, eine Reflektorschicht auf. Einer der Kontakte, vorzugsweise der Kontakt mit der Kontaktschicht, kann die Reflektorschicht umfassen. Die Reflektorschicht ist zweckmäßigerweise auf einer vom Halbleiterkörper abgewandten Seite der Kontaktschicht angeordnet. Die Reflektorschicht ist weiterhin bevorzugt zwischen der Anschlussfläche eines der Kontakte, besonders bevorzugt zwischen den Anschlussflächen beider Kontakte, und dem Halbleiterkörper angeordnet. Mittels der Reflektorschicht kann im aktiven Bereich erzeugte und in Richtung der Anschlussseite aus dem Halbleiterkörper austretende Strahlung in den Halbleiterkörper zurückreflektiert werden. Eine Absorption von Strahlung in den Kontakten kann so vermindert werden. Die aus dem Bauelement auskoppelbare Strahlungsleistung wird folglich erhöht.

In einer weiteren bevorzugten Ausgestaltung wird das Verbundelement vor dem Aufbringen der Spiegelschicht bereichsweise mit einer Schutzschicht versehen. Die Schutzschicht wird bevorzugt nach dem Aufbringen der Spiegelschicht entfernt. Mittels der Schutzschicht kann erreicht werden, dass die Bereiche des Verbundelements, welche nicht unmittelbar mit der Spiegelschicht bedeckt werden sollen, geschützt sind. Eventuell auf die Schutzschicht gelangendes Material für die Spiegelschicht kann zusammen mit der Schutzschicht entfernt werden. Von besonderem Vorteil ist es, die Kontakte mit der Schutzschicht zu bedecken. Ein Kurzschluss der Kontakte durch elektrisch leitfähiges Spiegelschichtmaterial kann so vermieden werden.

In einer weiteren bevorzugten Ausgestaltung wird eine für das Ausbilden der Auskoppelfläche vorgesehene Fläche des Verbundelements zunächst verspiegelt, und die Spiegelschicht wird nachfolgend für das Ausbilden der Auskoppelfläche wieder entfernt. Vorzugsweise wird die Spiegelschicht für die Auskoppelfläche vor dem Vereinzeln des Verbundelements in Bauelemente von dem Verbundelement entfernt. Die Spiegelschicht kann beispielsweise mittels eines mechanischen Prozesses, z. B. mittels Abschleifen, entfernt werden.

In einer weiteren bevorzugten Ausgestaltung wird die für das Ausbilden der Auskoppelfläche vorgesehene Fläche des Verbundelements mit der Schutzschicht versehen, die Schutzschicht nachfolgend verspiegelt und die verspiegelte Schutzschicht daraufhin wieder entfernt. Vorzugsweise wird die Schutzschicht vor dem Vereinzeln des Verbundelements entfernt. Auch auf diese Weise kann eine unverspiegelte Auskoppelfläche des Bauelements geschaffen werden.

In einer weiteren bevorzugten Ausgestaltung ist eine für das Ausbilden der Auskoppelfläche vorgesehene Seite des Verbundelements, insbesondere eine für das Ausbilden der Auskoppelfläche vorgesehene Fläche des Verbundelements, beim Aufbringen der Spiegelschicht abgeschattet. Ist diese Seite bezüglich des Aufbringens von Material für die Spiegelschicht auf das Verbundelement abgeschattet, so wird die für das Ausbilden der Auskoppelfläche vorgesehene Seite des Verbundelements und damit auch die Auskoppelfläche nicht mit Material der Spiegelschicht bedeckt. Das Verbundelement kann hierzu derart auf einem Hilfsträger angeordnet sein, dass die für die Ausbildung der Auskoppelfläche vorgesehene Seite dem Hilfsträger zugewandt ist.

Alternativ kann es auch zweckmäßig sein, das Verbundelement mit der Anschlussseite derart auf dem Hilfsträger anzuordnen, dass die Anschlussseite beim Aufbringen der Spiegelschicht abgeschattet ist. In diesem Fall ist die Anschlussseite dem Hilfsträger zugewandt.

In einer weiteren bevorzugten Ausgestaltung wird die Auskoppelfläche eines Bauelements beim Vereinzeln des Verbundelements geschaffen. Beispielsweise werden beim Vereinzeln des Verbundelements zwei Bauelemente mit einander zugewandten Auskoppelflächen gebildet.

In einer weiteren bevorzugten Ausgestaltung weist die Auskoppelfläche des Bauelements Erhebungen und Vertiefungen auf. Für das Vereinzeln und insbesondere beim Vereinzeln des Bauelements kann eine Mehrzahl von Vertiefungen in der Auskoppelfläche gebildet werden. Die Vertiefungen können beispielsweise durch Ritzen, insbesondere mittels eines Lasers, erzeugt sein. Zwischen zwei benachbarten Vertiefungen ist eine Erhebung gebildet. Weist die Auskoppelfläche eine strukturierte Oberfläche auf, so wird mit Vorteil die Strahlungsauskopplung seitens der Auskoppelfläche vereinfacht. Insbesondere kann Totalreflexion an der Auskoppelfläche aufgrund der Struktur der Auskoppelfläche gestört werden.

In einer weiteren bevorzugten Ausgestaltung wird das Verbundelement, insbesondere nach dem Vorsehen der Kontakte, - gegebenenfalls bis auf die abgeschattete Seite - allseitig und vorzugsweise vollflächig verspiegelt.

Das fertige Bauelement kann - bis auf die Auskoppelfläche und vorzugsweise die Anschlussseite - allseitig und insbesondere aussenseitig verspiegelt sein. Strahlung wird im Bauelement aufgrund der Reflexion an den verspiegelten Seiten zur Auskoppelfläche geleitet. Über eine allseitige Verspiegelung kann eine besonders große spezifische Ausstrahlung seitens der unverspiegelten Auskoppelfläche erzielt werden.

Eine, eine Mehrzahl von oder alle verspiegelten Seiten oder Flächen des Bauelements können vollflächig verspiegelt sein.

Die Auskoppelfläche kann mittels einer Oberfläche des Trägers, vorzugsweise einer Seitenfläche des Trägers, z. B. für ein seitlich emittierendes Bauelement, oder der der Anschlussseite abgewandten Oberfläche des Trägers, z. B. für ein oberflächenemittierendes Bauelement, oder mittels einer Oberfläche des Halbleiterkörpers, vorzugsweise einer Seitenfläche des Halbleiterkörpers, z. B. für ein seitlich emittierendes Bauelement oder der der Anschlussseite abgewandten Oberfläche des Halbleiterkörpers, z. B. für ein oberflächemittierendes Bauelement, gebildet sein. Das Ausbilden einer Auskoppelfläche mittels einer Oberfläche des Halbleiterkörpers ist für trägerlose Bauelemente besonders zweckmäßig.

In einer weiteren bevorzugten Ausgestaltung ist die dem Halbleiterkörper abgewandte Seite des Trägers, eine oder eine

Mehrzahl von den Träger begrenzenden Seitenflächen und/oder eine oder eine Mehrzahl von den Halbleiterkörper begrenzenden Seitenflächen verspiegelt. Alternativ oder ergänzend kann die dem Halbleiterkörper zugewandte Seite des Trägers, insbesondere in Bereichen, in denen der Träger frei vom Halbleiterkörper ist, verspiegelt sein.

In einer weiteren bevorzugten Ausgestaltung wird eine Mehrzahl von auf einem Hilfsträger angeordneten Verbundelementen bereitgestellt. Der Hilfsträger ist vorzugsweise dehnbar. Der dehnbare Hilfsträger wird bevorzugt vor dem Aufbringen der Spiegelschicht, die zum Beispiel auf die Mehrzahl von Verbundelementen aufgebracht wird, expandiert, so dass ein Zwischenraum zwischen benachbarten Verbundelementen beim Aufbringen der Spiegelschicht vergrößert ist. Die Verspiegelung von einander zugewandten Flächen benachbarter Verbundelemente wird so erleichtert.

In einer weiteren bevorzugten Ausgestaltung werden die Verbundelemente durch Vereinzeln eines Ausgangsverbundes erhalten. Der Ausgangsverbund wird vorzugsweise vor dem Vereinzeln des Ausgangsverbundes auf dem Hilfsträger angeordnet, so dass die vereinzelten Verbundelemente durch den Hilfsträger stabilisiert werden und insbesondere vom Hilfsträger in einem Verbund gehalten werden. Der Ausgangsverbund kann eine Halbleiterschichtstruktur umfassen, aus der vor dem Vereinzeln des Ausgangsverbundes die Halbleiterkörper ausgebildet werden. Weiterhin werden die Kontakte vorzugsweise vor dem Vereinzeln des Ausgangsverbundes ausgebildet.

Das Bauelement ist als seitlich emittierendes Bauelement (sogenannter Side-Looker) und nicht als oberflächenemittierendes Bauelement (sogenannter Top-Looker) ausgebildet.

Dies Auskoppelfläche des Bauelements verläuft quer zur lateralen Haupterstreckungsrichtung des aktiven Bereichs und insbesondere quer zur Anschlussfläche. Die Auskoppelfläche kann durch eine den Träger lateral begrenzende Seitenfläche gebildet sein. Über die Verspiegelung wird die Strahlung zu dieser Auskoppelfläche gelenkt. Ein derartiger Side-Looker kann kostengünstig im Verbund gefertigt werden. Ein seitlich emittierendes Bauelement kann Strahlung parallel zu einer Montagefläche emittieren, in der dieses Bauelement auf dem Anschlussträger montiert ist.

Für ein Side-Looker-Bauelement hat es sich als besonders vorteilhaft erwiesen, dass sich eine verspiegelte Fläche des Bauelements, welche schräg - insbesondere unter einem von 90° verschiedenen, vorzugsweise spitzen Winkel - zum aktiven Bereich verläuft, über den aktiven Bereich erstreckt. Bevorzugt überdeckt diese Fläche den aktiven Bereich, vollständig. Besonders bevorzugt ist diese Fläche auf der der Anschlussseite abgewandten Seite des aktiven Bereichs angeordnet.

Bei einem Top-Looker kann die dem Halbleiterkörper abgewandte Seite des Trägers als Auskoppelfläche ausgebildet sein. Ein Top-Looker kann Strahlung senkrecht zu der Montagefläche des Bauelements auf dem Anschlussträger emittieren.

Das Bauelement ist vorzugsweise als chipartiges, insbesondere flip-chip-artiges Bauelement ausgebildet. Weiterhin kann das Bauelement in Chipgröße ausgeführt sein. Eine laterale Ausdehnung des Bauelements in Aufsicht auf den aktiven Bereich ist gegenüber der lateralen Ausdehnung des aktiven Bereichs bei einem Bauelement in Chipgröße vorteilhaft gering.

Das Verhältnis des Flächeninhalts der vom Halbleiterkörper überdeckten Fläche in Aufsicht auf die Anschlussseite zu dem Inhalt der gesamten Fläche, über die sich das Bauelement in Aufsicht auf die Anschlussseite erstreckt, kann bei dem Bauelement größer als 0,2, bevorzugt größer als 0,3, besonders bevorzugt größer als 0,5, am meisten bevorzugt größer als 0,7 sein.

Ferner kann bei dem hierin beschriebenen Bauelement auf ein zusätzliches, das Bauelement schützendes Gehäuse, in dem das Bauelement montiert wird und das nicht im Verbund gemeinsam mit dem Bauelement hergestellt wird, verzichtet werden. Weitere Merkmale, Vorteile und vorteilhafte Ausgestaltungen ergeben sich aus der folgenden Beschreibung der Ausführungsbeispiele in Verbindung mit den Figuren.
Figur 1 zeigt ein erstes Ausführungsbeispiel eines optoelektronischen Bauelements anhand einer schematischen Aufsicht in Figur 1A, zwei schematischen Schnittansichten in den Figuren 1B und 1C, einer vereinfachten schematischen Schnittansicht in Figur 1D und einer Teilschnittansicht in Figur 1E.
Figur 2 zeigt ein weiteres Beispiel eines optoelektronischen Bauelements anhand einer schematischen Aufsicht in Figur 2A und einer schematischen Schnittansicht in Figur 2B.
Figur 3 zeigt ein Ausführungsbeispiel für ein Verfahren zur Herstellung einer Mehrzahl von optoelektronischen Bauelementen anhand der in den Figuren 3A bis 3D schematisch dargestellten Zwischenschritte.
Figur 4 ein weiteres Beispiel für ein Verfahren zur Herstellung einer Mehrzahl von optoelektronischen Bauelementen anhand der in den Figuren 4A und 4B schematisch dargestellten Zwischenschritte.
Figur 5 zeigt schematisch einen Zwischenschritt eines weiteren Beispiels für ein Verfahren zur Herstellung einer Mehrzahl von optoelektronischen Bauelementen.
Figur 6 zeigt ein weiteres Ausführungsbeispiel eines optoelektronischen Bauelements 1 anhand einer schematischen Schnittansicht.
Figur 7 zeigt ein weiteres Ausführungsbeispiel eines optoelektronischen Bauelements anhand einer schematischen Schnittansicht.
Figur 8 zeigt ein weiteres Ausführungsbeispiel eines optoelektronischen Bauelements anhand einer schematischen Schnittansicht.
Figur 9 zeigt ein weiteres Ausführungsbeispiel eines optoelektronischen Bauelements anhand einer schematischen Schnittansicht.

Gleiche, gleichartige und gleich wirkende Elemente sind in den Figuren mit gleichen Bezugszeichen versehen.

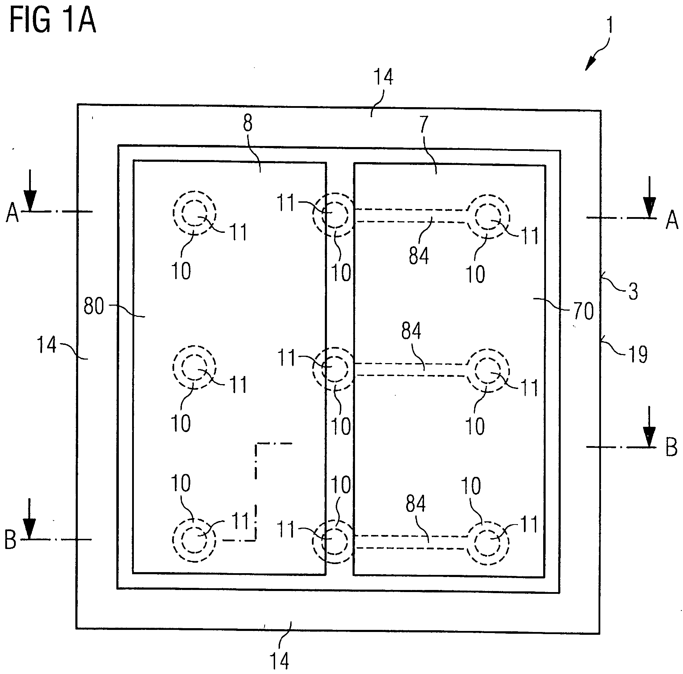

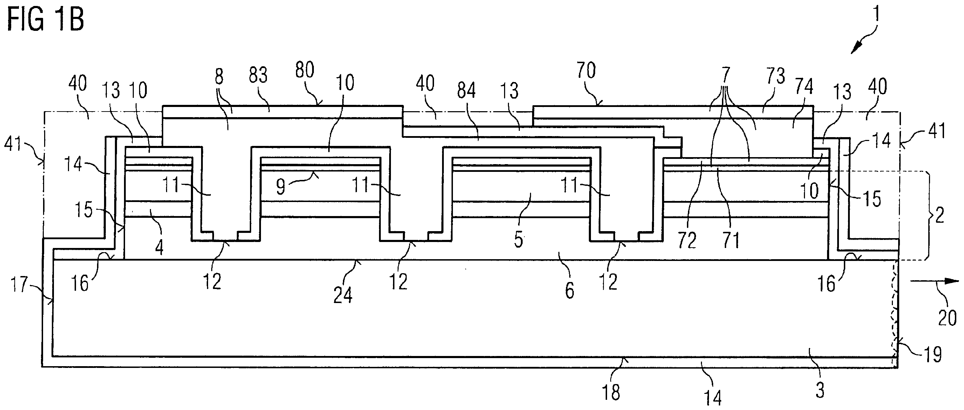

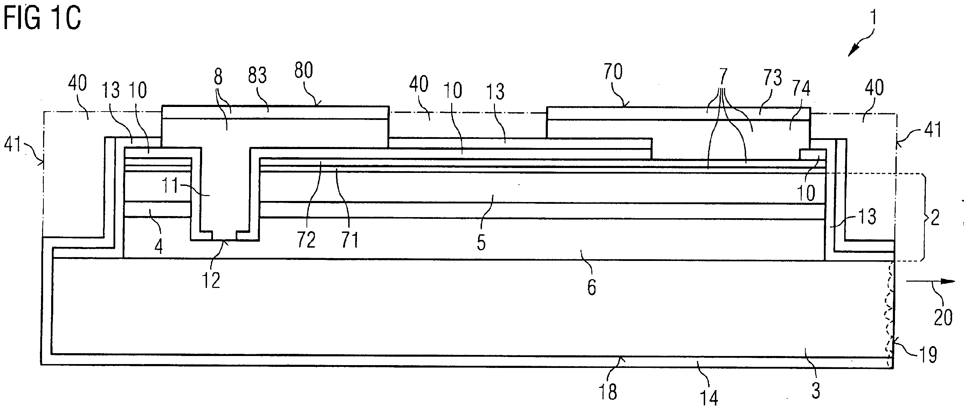

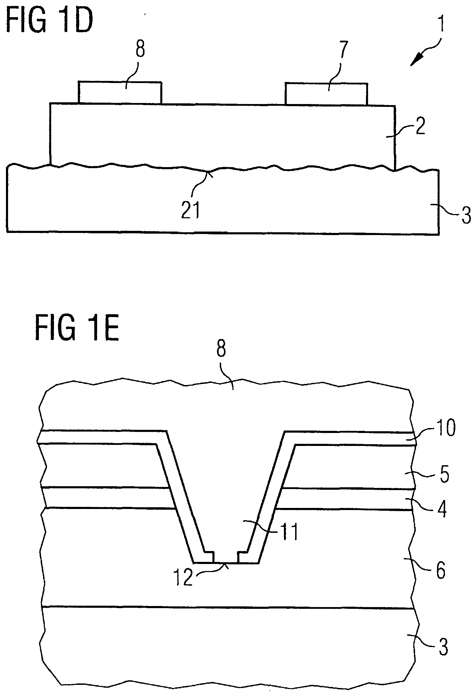

Figur 1 zeigt ein erstes Ausführungsbeispiel eines optoelektronischen Bauelements anhand einer schematischen Aufsicht in Figur 1A, zwei schematischen Schnittansichten in den Figuren 1B und 1C, einer vereinfachten schematischen Schnittansicht in Figur 1D und einer Teilschnittansicht in Figur 1E. Figur 1B entspricht dabei einem Schnitt entlang der Linie A-A in Figur 1A und Figur 1C entspricht einem Schnitt entlang der Linie B-B in Figur 1A.

Das optoelektronische Bauelement 1 weist einen Halbleiterkörper 2 auf. Der Halbleiterkörper ist auf einem Träger 3 angeordnet, den das Bauelement 1 aufweist. Der Halbleiterkörper 2 umfasst eine Halbleiterschichtenfolge mit einem zur Strahlungserzeugung geeigneten aktiven Bereich 4. Die Halbleiterschichtenfolge kann insbesondere eine Mehrzahl von Halbleiterschichten umfassen, zwischen denen der aktive Bereich angeordnet ist. Weiterhin bildet die Halbleiterschichtenfolge bevorzugt den Halbleiterkörper.

Der Halbleiterkörper 2 ist bevorzugt als Lumineszenzdioden-Halbleiterkörper ausgebildet. Insbesondere umfasst der Halbleiterkörper bevorzugt zwei Bereiche 5, 6 mit unterschiedlichen Leitungstypen (n-leitend oder p-leitend). Zwischen diesen Bereichen 5 und 6 ist zweckmäßigerweise der aktive Bereich 4 angeordnet oder ausgebildet.

Der aktive Bereich 4 umfasst bevorzugt eine Heterostruktur, insbesondere eine Doppelheterostruktur, oder eine Quantenstruktur, besonders bevorzugt eine Ein- oder Mehrfach-Quantentopfstruktur, eine Quantendrahtstruktur oder eine Quantenpunktstruktur. Derartige Strukturen zeichnen sich durch besonders hohe interne Quanteneffizienzen bei der Strahlungserzeugung im aktiven Bereich aus.

Die Halbleiterschichtenfolge ist bevorzugt epitaktisch auf einem Aufwachssubstrat gewachsen. Der Träger 3 kann beim Herstellen des Bauelements 1 aus dem Aufwachssubstrat ausgebildet sein oder vom Aufwachssubstrat verschieden sein. Im letzteren Fall wird der Träger 3 oder Material, aus dem der Träger ausgebildet wird, bevorzugt auf das gewachsene Halbleitermaterial aufgebracht, bevor das Aufwachssubstrat von dem gewachsenen Halbleitermaterial entfernt wird. Eine mechanische Stabilisierung des gewachsenen Halbleitermaterials ist durch den Träger 3 auch bei einem entfernten Aufwachssubstrat gegeben. Ist der Träger 3 vom Aufwachssubstrat verschieden, so kann der Träger als harter Trägerkörper mit dem gewachsenen Halbleitermaterial verbunden werden oder es kann zunächst eine Formmasse auf den Halbleiterkörper aufgebracht werden, welche nachfolgend für die Ausbildung eines Trägers gehärtet wird. Für eine derartige Formmasse eignet sich beispielsweise BCB (Benzo-Cyclo-Buten). Als harter Trägerkörper eignet sich beispielsweise ein Glas.

Der Träger 3 ist vorzugsweise strahlungsdurchlässig für im aktiven Bereich 4 zu erzeugende Strahlung ausgebildet, sodass die Strahlung aus dem aktiven Bereich in den Träger eintreten und nachfolgend über den Träger aus dem Bauelement 1 auskoppeln kann.

In einer bevorzugten Ausgestaltung enthält die Halbleiterschichtenfolge, insbesondere die Bereiche 5 und 6 des Halbleiterkörpers und/oder der aktive Bereich 4, ein III-V-Halbleitermaterial. Mittels III-V-Verbindungshalbleitermaterialien, insbesondere Nitrid-Verbindungshalbleitermaterialien, Phosphid-Verbindungshalbleitermaterialien oder Arsenid-Verbindungshalbleitermaterialien, können bei der Strahlungserzeugung vereinfacht hohe interne Quanteneffizienzen bei der Umwandlung von elektrischer Leistung in Strahlungsleistung erzielt werden. Bevorzugt basiert der aktive Bereich und insbesondere der Halbleiterkörper daher auf einem der genannten Materialsysteme.

"Auf Phosphid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘP umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Nitrid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘN umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Arsenid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘAS umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Als Aufwachssubstrat sind für Nitrid-Verbindungshalbleiter z.B. Saphir-, SiC- oder GaN-Aufwachssubstrate, für Phosphid- und Arsenid-Verbindungshalbleiter ist beispielsweise ein GaAs-Aufwachssubstrat geeignet.

Nitrid- und Phosphid-Verbindungshalbleitermaterialien sind für die Erzeugung sichtbarer Strahlung besonders geeignet. Arsenid-Verbindungshalbleitermaterialien sind für den infraroten Spektralbereich besonders geeignet. Nitrid-Verbindungshalbleitermaterialien eignen sich dabei besonders für die Erzeugung von Strahlung vom ultravioletten über den blauen bis in den grünen Spektralbereich und Phosphid-Verbindungshalbleitermaterialien für Strahlung vom orangen bis in den roten Spektralbereich.

Bevorzugt ist das Bauelement 1 und insbesondere dessen aktiver Bereich 4 zur Erzeugung sichtbarer Strahlung ausgebildet. Weiterhin ist das Bauelement vorzugsweise als LED-Bauelement zur Abstrahlung inkohärenter Strahlung ausgebildet.

Das optoelektronische Bauelement 1 weist zwei elektrische Kontakte, einen ersten Kontakt 7 und einen zweiten Kontakt 8, auf. Die Kontakte 7 und 8 sind mit dem Halbleiterkörper 2 auf verschiedenen Seiten des aktiven Bereichs 4 elektrisch leitend verbunden. Über die Kontakte 7 und 8 können im Betrieb des Bauelements Ladungsträger in den aktiven Bereich injiziert werden. Diese können dort unter Strahlungserzeugung rekombinieren. Die Kontakte 7 und 8 sind auf der vom Träger 3 abgewandten Seite des Halbleiterkörpers angeordnet.

Die Kontakte 7, 8 weisen jeweils eine Anschlussfläche 70 bzw. 80 auf. Die Anschlussflächen sind jeweils vom Halbleiterkörper 2 abgewandt. Die Anschlussflächen 70, 80 sind weiterhin auf der gleichen Seite des Halbleiterkörpers 2 und insbesondere auf der gleichen Seite des aktiven Bereichs 4 - der Anschlussseite des Bauelements 1 - angeordnet. Die Anschlussseite des Bauelements ist bevorzugt auf der dem Träger 3 abgewandte Seite des Halbleiterkörpers 2 ausgebildet. Figur 1A zeigt eine Aufsicht auf die Anschlussseite des Bauelements.

Die Anschlussflächen 70 und 80 erstrecken sich ferner über eine gemeinsame Oberfläche 9 des Halbleiterkörpers. Diese Oberfläche ist zwischen dem aktiven Bereich 4 und den Anschlussflächen beider Kontakte angeordnet. Die Anschlussflächen 70 und 80 sind lateral nebeneinander auf der Oberfläche 9 angeordnet. Die Kontakte 7 und 8 können insbesondere auf diese Oberfläche 9 des Halbleiterkörpers 2 aufgebracht sein.

Die Anschlussflächen 70, 80 sind vorzugsweise zur elektrisch leitenden Verbindung des optoelektronischen Bauelements mit Anschlussleitern eines externen Anschlussträgers, z. B. Leiterbahnen einer Leiterplatte, vorgesehen. Besonders bevorzugt sind die Anschlussflächen 70 und 80 der Kontakte dem Anschlussträger bei der Montage des Bauelements auf dem Anschlussträger zugewandt. Die Anschlussseite des Bauelements kann also zugleich die Montageseite des Bauelements für die Montage auf dem Anschlussträger (nicht explizit dargestellt) bilden. Das Bauelement kann somit als flip-chip-artiges Bauelement ausgebildet sein.

Die Kontakte 7, 8 können beispielsweise unter Abscheiden von Material für die Kontakte auf die Oberfläche 9 des Halbleiterkörpers 2 ausgebildet sein. Das Abscheiden kann z.B. mittels eines PVD- oder CVD-Verfahrens, etwa über Sputtern, Aufdampfen oder reaktives Sputtern, erfolgen.

Die Kontakte sind bevorzugt auf Metallbasis ausgebildet. Die Kontakte können insbesondere eine metallbasierte Legierung, z.B. AuSn oder AuZn, oder ein Metall, z.B. Au, Al, Ag, Pt oder Ti, enthalten und insbesondere aus einer oder einer Mehrzahl von metallbasierten Legierungen und/oder einem oder einer Mehrzahl von Metallen bestehen.

Der erste Kontakt 7 ist auf der den Anschlussflächen 70, 80 zugewandten Seite des Halbleiterkörpers 2 elektrisch leitend mit diesem verbunden. Insbesondere ist der erste Kontakt 7 mit dem Bereich 5 des Halbleiterkörpers elektrisch leitend verbunden. Der zweite Kontakt 8 ist auf der den Anschlussflächen 70, 80 abgewandten Seite des aktiven Bereichs elektrisch leitend mit dem Halbleiterkörper 2, insbesondere dem Bereich 6 des Halbleiterkörpers, elektrisch leitend verbunden. Anschlussseitig und insbesondere von der Oberfläche 9 bis zu der dieser Oberfläche abgewandten Seite des aktiven Bereichs 3 sind die beiden Kontakte elektrisch voneinander isoliert.

Der erste Kontakt 7 umfasst eine Kontaktschicht 71. Diese ist, insbesondere direkt, über die Oberfläche 9 mit dem Halbleiterkörper 2 elektrisch leitend verbunden. Über die großflächige Kontaktschicht können anschlussseitig großflächig Ladungsträger in den Halbleiterkörper injiziert werden. Weiterhin umfasst der erste Kontakt 7 bevorzugt eine Reflektorschicht 72. Diese ist vorzugsweise auf der vom Halbleiterkörper abgewandten Seite der Kontaktschicht 71 angeordnet. Die Reflektorschicht 72 erstreckt sich bevorzugt, ebenso wie die Kontaktschicht 71, großflächig über die Oberfläche 9 des Halbleiterkörpers. Die Kontaktschicht 71 und vorzugsweise die Reflektorschicht 72 ist zwischen der Anschlussfläche 80 des zweiten Kontakts 8 und der Oberfläche 9 angeordnet. Die Kontaktschicht 71 und vorzugsweise die Reflektorschicht 72 erstreckt sich von der Anschlussfläche des ersten Kontakts 7 bis unter die Anschlussfläche 80 des zweiten Kontakts 8.

Der erste Kontakt 7 weist seitens der Anschlussfläche 70 bevorzugt eine Anschlussschicht 73, besonders bevorzugt eine Lotschicht, z. B. eine Gold-Zinn-Lotschicht, auf. Der zweite Kontakt 8 weist anschlussseitig bevorzugt eine Anschlussschicht 83, vorzugsweise eine Lotschicht, beispielsweise eine Gold-Zinn-Lotschicht, auf. Die vom Halbleiterkörper 2 abgewandte Oberfläche der Anschlussschichten 73 und 83 bildet bevorzugt die Anschlussfläche des jeweiligen Kontakts.

Die Anschlussfläche 70 des ersten Kontakts 7 ist bevorzugt über eine weitere Schicht 74 des ersten Kontakts elektrisch leitend mit der Kontaktschicht verbunden.

Über die Kontaktschicht 71 können Ladungsträger großflächig in den Halbleiterkörper injiziert werden. Eine metallhaltige Kontaktschicht 71 kann zwar bereits ein vergleichsweise großes Reflexionsvermögen für die im aktiven Bereich zu erzeugende Strahlung zeigen. Es ist jedoch von Vorteil, eine gesonderte Reflektorschicht vorzusehen, da die jeweiligen Schichten dann auf die jeweilige Funktion hin optimiert werden können. Die Kontaktschicht 71 kann also zur elektrischen Kontaktbildung zum Halbleiterkörper optimiert werden und z.B. semitransparent ausgeführt sein, während die Reflektorschicht hinsichtlich hoher Reflektivität für die im aktiven Bereich zu erzeugende Strahlung ausgebildet werden kann. Auf elektrische Kontakteigenschaften der Reflektorschicht zum Halbleitermaterial muss nicht geachtet werden.

Bei Nitrid-Verbindungshalbleitermaterialien eignet sich beispielsweise Pt besonders für eine Kontaktschicht 71 zu p-leitendem Halbleitermaterial und Al hinsichtlich hoher Reflektivität für die Reflektorschicht 72.

P-leitende Nitrid-Materialien, insbesondere GaN, zeigen oftmals eine geringe Leitfähigkeit in lateraler Richtung. Daher ist es von Vorteil, Ladungsträger bereits großflächig in den Halbleiterkörper zu injizieren anstatt auf Stromaufweitung im Halbleiterkörper 2 für eine großflächige Ladungsträgerinjektion in den aktiven Bereich zu setzen. Bevorzugt ist der Bereich 5 des Halbleiterkörpers 2 p-leitend ausgebildet.

Um einen anschlussseitigen Kurzschluss der Kontakte 7 und 8 zu vermeiden, sind die Kontakte anschlussseitig elektrisch voneinander isoliert. Zwischen der Anschlussfläche 80 des zweiten Kontakts und der Kontaktschicht 71 sowie gegebenenfalls zwischen der Reflektorschicht 72 und der Anschlussfläche 80 ist eine erste Isolationsschicht 10 angeordnet. Diese Isolationsschicht isoliert den zweiten Kontakt 8 anschlussseitig von dem ersten Kontakt 7 und insbesondere isoliert sie den zweiten Kontakt 8 von der Oberfläche 9 des Halbleiterkörpers 2. Die Isolationsschicht 10 ist vorzugsweise vollflächig zwischen der Kontaktschicht 71 und dem zweiten Kontakt 8 angeordnet.

Der Kontakt 8 erstreckt sich durch einen oder vorzugsweise eine Mehrzahl von Durchbrüchen durch den aktiven Bereich 4 von der den Anschlussflächen 80 und 70 zugewandten Seite des Halbleiterkörpers bis zu der den Anschlussflächen abgewandten Seite des aktiven Bereichs. Hierzu weist der Halbleiterkörper 2 eine oder eine Mehrzahl von Ausnehmungen 11 auf, durch die sich der zweite Kontakt 8 erstreckt. Die Ausnehmung(en) ist (sind) bevorzugt lokal im Halbleiterkörper ausgebildet. Die Ausnehmung(en) 11 ist (sind) vorzugsweise lateral umlaufend vom Halbleiterkörper begrenzt.

Die Wand der Ausnehmung ist mit einem Isolationsmaterial, vorzugsweise der Isolationsschicht 10, ausgekleidet, welches auf der den Anschlussflächen abgewandten Seite des aktiven Bereichs 4 für eine Kontaktstelle 12 ausgespart ist. Über die Kontaktstelle 12 ist der zweite Kontakt 8 mit dem Halbleiterkörper, vorzugsweise direkt mit dem Bereich 6 des Halbleiterkörpers, elektrisch leitend verbunden. Die Kontaktstelle 12 ist zweckmäßigerweise am Boden der (jeweiligen) Ausnehmung 11 ausgebildet.

Die Isolationsschicht 10 enthält z.B. ein Siliziumnitrid, wie SiN, ein Siliziumoxid, wie SiO₂, oder ein Siliziumoxinitrid, wie SiON.

Für den Durchtritt des zweiten Kontakts 8 ist die Kontaktschicht 71 und gegebenenfalls die Reflektorschicht 72 vorzugsweise ausgespart. Abgesehen von den Aussparungen für den Kontaktdurchtritt des zweiten Kontakts 8 ist die Kontaktschicht 71 und vorzugsweise die Reflektorschicht 72 vorzugsweise durchgehend ausgeführt. Die Kontaktschicht und vorzugsweise die Reflektorschicht kann abgesehen von den für den Durchtritt des zweiten Kontakts 8 ausgesparten Bereichen die gesamte, den Anschlussflächen 70, 80 zugewandte Oberfläche 9 des Halbleiterkörpers 2 bedecken.

Die lokalen Kontaktstellen 12 sind zweckmäßigerweise über die Ausdehnung des Halbleiterkörpers verteilt. Vorzugsweise sind die Kontaktstellen gleichmäßig in einem Raster, beispielsweise gitterpunktartig, verteilt. Über die Kontaktstellen können so lateral über den Halbleiterkörper verteilt Ladungsträger lokal in den Halbleiterkörper gelangen. Zweckmäßigerweise weist das Halbleitermaterial des Halbleiterkörpers, welches über den zweiten Kontakt 8 kontaktiert wird, eine höhere Leitfähigkeit in lateraler Richtung - also parallel zum aktiven Bereich - auf als das Material, welches mit dem ersten Kontakt 7 kontaktiert wird. Trotz der nur stellenweisen Kontaktierung des Halbleiterkörpers 2 über den zweiten Kontakt 8 kann so über Stromaufweitung im Halbleiterkörper eine homogene Stromverteilung in lateraler Richtung erreicht werden. Eine großflächige Ladungsträgerinjektion in den aktiven Bereich kann so trotz der lokalen Ladungsträgerinjektion erreicht werden.

Bei Nitrid-Verbindungshalbleitermaterialien weist n-leitendes Material, z.B. n-GaN, oftmals eine erheblich größere Leitfähigkeit in lateraler Richtung auf als p-leitendes Material, z.B. p-GaN. Der Bereich 6 des Halbleiterkörpers ist bevorzugt n-leitend und der Bereich 5 des Halbleiterkörpers p-leitend ausgebildet.

Eine oder eine Mehrzahl von Durchbrüchen durch den aktiven Bereich, insbesondere eine Mehrzahl von Ausnehmungen 11 des Halbleiterkörpers, erstreckt sich vorzugsweise unterhalb der Anschlussfläche 80 des zweiten Kontakts 8 durch den aktiven Bereich 4 (vergleiche die Aufsicht in Figur 1A).

Eine oder eine Mehrzahl von Durchbrüchen durch den aktiven Bereich, insbesondere eine Mehrzahl von Ausnehmungen 11 des Halbleiterkörpers, erstreckt sich vorzugsweise unterhalb der Anschlussfläche 70 des ersten Kontakts 7 durch den aktiven Bereich 4 (vergleiche die Aufsicht in Figur 1A).

Bevorzugt weist der zweite Kontakt 8 einen oder eine Mehrzahl von Kontaktfortsätzen 84 auf. Der jeweilige Kontaktfortsatz erstreckt sich bevorzugt von der Anschlussfläche 80 des zweiten Kontakts 8 weg. Beispielsweise kann der Kontaktfortsatz bahnenartig verlaufen. Bevorzugt erstreckt sich der (jeweilige) Kontaktfortsatz 84 von der Anschlussfläche 80 weg über die Oberfläche 9 und besonders bevorzugt über eine Mehrzahl von Durchbrüchen, insbesondere Ausnehmungen 11 hinweg.

Weiterhin ist der jeweilige Kontaktfortsatz 84 zwischen der Anschlussfläche 70 des ersten Kontakts und dem Halbleiterkörper angeordnet. Über den Kontaktfortsatz können die sich durch weitere Ausnehmungen des Halbleiterkörpers erstreckenden Teile des Kontakts, über die sich der jeweilige Kontaktfortsatz erstreckt, elektrisch leitend mit der Anschlussfläche 80 verbunden sein. Die Ausnehmungen 11 sind vorzugsweise mit Kontaktmaterial befüllt.

Zweckmäßigerweise ist zwischen dem Kontaktfortsatz 84 und der Anschlussfläche 70 des ersten Kontakts 7 eine zweite Isolationsschicht 13 angeordnet. Diese Isolationsschicht 13 isoliert zweckmäßigerweise den Kontaktfortsatz 84 und den ersten Kontakt 7 elektrisch voneinander. Der Kontaktfortsatz kann zwischen den beiden Isolationsschichten 10 und 13 verlaufen. Insbesondere kann der jeweilige Kontaktfortsatz in Isolationsmaterial eingebettet sein. In Bereichen, in denen kein Kontaktfortsatz angeordnet ist, grenzen die beiden Isolationsschichten vorzugsweise aneinander an. Für die zweite Isolationsschicht 13 eignen sich z.B. die oben für die erste Isolationsschicht 10 angegebenen Materialien.

Eine derartige Kontaktstruktur erleichtert es - trotz der Anordnung der Anschlussflächen 70 und 80 auf der gleichen Seite des Halbleiterkörpers und insbesondere über der gleichen Fläche - eine beidseitig homogene und großflächige Ladungsträgerinjektion in den aktiven Bereich 4 zu erzielen. Die Effizienz des Bauelements bei der Strahlungserzeugung wird so erhöht.

Über die Reflektorschicht 72 kann einer Absorption von Strahlung in auf der dem aktiven Bereich 4 abgewandten Seite der Reflektorschicht angeordneten Strukturen, beispielsweise Leiterbahnen einer Leiterplatte, auf der das Bauelement montiert wird, vorgebeugt werden.

Zur Herstellung der Kontaktstruktur wird beispielsweise zunächst die Kontaktschicht 71 und gegebenenfalls die Reflektorschicht 72, vorzugsweise ganzflächig, auf Material für den Halbleiterkörper 2 abgeschieden. Nachfolgend können die Kontaktschicht und der Halbleiterkörper bereichsweise, z.B. mittels Ätzen und einer geeigneten strukturierten Maske, für die Ausnehmungen entfernt werden und die Isolationsschicht 10 vorgesehen werden. Diese Isolationsschicht wird vorzugsweise vollflächig abgeschieden und nachfolgend für die Kontaktstellen ausgespart, z.B. über Ätzen unter Verwendung einer geeigneten strukturierten Maske.

Daraufhin kann der zweite Kontakt 8 aufgebracht werden. Kontaktfortsätze 84 können daraufhin mit der zweiten Isolationsschicht bedeckt werden. Nachfolgend kann der von der Kontaktschicht 71 verschiedene Teil des ersten Kontakts 7 aufgebracht werden.

Die mehrlagige Struktur des ersten Kontakts 7 - eine Lage mit der Kontaktschicht und gegebenenfalls der Reflektorschicht einerseits und eine weitere Lage mit dem verbleibenden Teil des ersten Kontakts andererseits - erleichtert dabei in Kombination mit der elektrischen Isolation der beiden Kontakte voneinander das Ausbilden einer Kontaktstruktur für das optoelektronische Bauelement 1. Die Kontaktfortsätze können insbesondere nahezu beliebig geformt und verteilt über den Halbleiterkörper verlaufen.

Aufgrund der beidseitigen Isolierung des zweiten Kontakts - einerseits anschlussseitig vom Halbleiterkörper und andererseits vom zweiten Kontakt mittels der Isolationsschichten 10 und 13 - wird das Ausbilden eines beliebigen Verlaufs von Kontaktfortsätzen über den Halbleiterkörper weitergehend vereinfacht. Weiterhin kann eine derartige Kontaktstruktur im Verbund, also gleichzeitig für eine Mehrzahl von Halbleiterkörpern, auf einfache Weise hergestellt werden.

Weiterhin liegen die Anschlussflächen 70, 80 vorzugsweise in einer gemeinsamen Ebene. Das Verbinden der Anschlussflächen mit externen Anschlussleitern wird so erleichtert. Das Bauelement kann komplett im Verbund gefertigt werden. Auf eine nachträgliche Kontaktierung der Anschlussflächen mit Bonddrähten kann verzichtet werden. Vielmehr können die Anschlussflächen der Bauelemente flip-chip-artig, vorzugsweise unmittelbar, mit externen Anschlussleitern elektrisch leitend verbunden werden, z. B. mittels eines elektrisch leitfähigen Klebstoffs oder eines Lots.

Das Bauelement 1 ist weiterhin bereichsweise verspiegelt. Hierzu sind Oberflächen des Bauelements, insbesondere Aussenflächen, mit einer Spiegelschicht 14 versehen. Die Spiegelschicht ist vorzugsweise auf dem Bauelement abgeschieden. Beispielsweise enthält die Spiegelschicht ein Metall. Die Spiegelschicht muss nicht notwendigerweise einstückig ausgeführt sein, sondern kann eine Mehrzahl von Spiegelschichtstücken umfassen. Dabei sind verschiedene Spiegelschichtstücke bevorzugt auf verschiedenen Oberflächen des Bauelements angeordnet.

Die Spiegelschicht 14 ist bevorzugt als Metallisierung oder metallbasierte Legierung ausgeführt. Hierzu ist beispielsweise Au, insbesondere für aktive Bereiche auf Phosphid-Verbindungshalbleiterbasis, oder Al oder Ag, insbesondere für aktive Bereiche auf Nitrid-Verbindungshalbleiterbasis, oder eine Legierung mit einem der genannten Metalle besonders geeignet.

Alternativ kann die Spiegelschicht 14 auch als dielektrischer Spiegel, insbesondere als Kaltlichtspiegel, ausgeführt sein. Mittels eines Kaltlichtspiegels kann selektiv eine hohe Reflektivität für im aktiven Bereich 4 erzeugte Strahlung erzielt werden, während z. B. Wärmestrahlung, welche aufgrund von Verlustwärme bei der Strahlungserzeugung im Halbleiterkörper 2 anfällt, vergleichsweise ungehindert durch die Spiegelschicht 14 hindurch aus dem Bauelement treten kann.

Für den Kaltlichtspiegel eignet sich beispielsweise eine Mehrschichtstruktur mit ausschließlich dielektrischen Schichten, insbesondere eine Abfolge einer Vielzahl von dielektrischen Schichtpaaren mit Schichten unterschiedlicher Brechungsindices, die in der Mehrschichtstruktur alternierend angeordnet werden.

Es kann auch vorteilhaft sein, einen dielektrischen Spiegel mit einer Spiegelmetallisierung oder Spiegellegierung für die Spiegelschicht zu kombinieren. Beispielsweise kann eine dielektrische Schicht, z. B. eine Siliziumdioxyd-Schicht, oder eine Schichtstruktur mit einer Mehrzahl von dielektrischen Schichten unterschiedlicher Brechungsindices vorgesehen werden und auf diese Schicht nachfolgend eine Metallisierungs- oder Legierungsschicht, z.B. eine Au-, Ag- oder Al-haltige Schicht, aufgebracht werden. Dielektrische Schichtstrukturen zeichnen sich durch eine große Winkelabhängigkeit der Reflektivität vom Auftreffwinkel der Strahlung auf die Schichtstruktur aus, während Metallschichten oder Legierungsschichten eine vom Auftreffwinkel weitgehend unabhängig hohe Reflektivität zeigen. Im aktiven Bereich erzeugte Strahlung kann an einer derartigen Kombination aus einem dielektrischen Spiegel, z.B. einem Kaltlichtspiegel, und einem Metall- beziehungsweise Legierungsspiegel zunächst auf den dielektrischen Spiegel treffen und dort reflektiert werden. Ein durch den dielektrischen Spiegel hindurchtretender Strahlungsanteil kann dann am Metall- beziehungsweise Legierungsspiegel reflektiert werden. Hohe Reflektivitäten können so auch mit Metall- beziehungsweise Legierungsschichten vergleichsweise geringer Reflektivität erzielt werden, da der dielektrische Spiegel zur gesamten Reflektivität der Spiegelschicht 14 beiträgt.

Eine Reflektivität der Spiegelschicht 14 für im aktiven Bereich 4 erzeugte Strahlung beträgt bevorzugt 80 % oder mehr, besonders bevorzugt 90 % oder mehr, am meisten bevorzugt 95 % oder mehr, z.B. 96 % oder mehr.

Mittels Verspiegelung des Bauelements 1 kann erreicht werden, dass Strahlung gezielt durch eine definierte Auskoppelfläche des Bauelements austritt. Die Spiegelschicht 14 kann Strahlung in Richtung dieser Auskoppelfläche lenken.

Seitenflächen 15 des Halbleiterkörpers 2, die diesen lateral begrenzen, sind vorzugsweise verspiegelt. Ist die Spiegelschicht, wie etwa im Falle einer Metallisierung, elektrisch leitfähig ausgebildet, so ist zweckmäßigerweise zwischen der Spiegelschicht 14 und dem Halbleiterkörper ein Isolationsmaterial, z.B. die Isolationsschicht 10, angeordnet, um einen Kurzschluss zu vermeiden.

Weiterhin ist die dem Halbleiterkörper 2 zugewandte und nicht mit dem Halbleiterkörper bedeckte Oberfläche 16 des Trägers 3 vorzugsweise verspiegelt. Ferner ist eine Seitenfläche 17 des Trägers 3, die diesen lateral begrenzt, vorzugsweise verspiegelt. Auch die vom Halbleiterkörper 2 abgewandte Oberfläche 18 des Trägers 3 ist vorzugsweise verspiegelt.

Mittels der Verspiegelung kann Strahlung im Bauelement in Richtung einer Auskoppelfläche des Bauelements gelenkt werden. Die auskoppelseitige Strahlungsleistung und damit die spezifische Ausstrahlung des Bauelements werden so erhöht.

Ist die Auskoppelfläche eine Fläche des Trägers, so ist der Träger 3 bevorzugt abgesehen von der Auskoppelfläche allseitig verspiegelt. Vorzugsweise ist das Bauelement abgesehen von der Auskoppelfläche und der Anschlussseite allseitig verspiegelt. Über die Verspiegelung kann eine Auskopplung über die Auskoppelfläche "erzwungen" werden.

Mittels einer Reflektorschicht 72 in den Kontakten kann jedoch auch ein anschlussseitiger Strahlungsaustritt aus dem Bauelement vermieden werden. Auf die Reflektorschicht treffende Strahlung wird vielmehr in den Halbleiterkörper zurückreflektiert wird und kann über die Auskoppelfläche aus dem Bauelement auskoppeln.

Vorliegend ist die Auskoppelfläche 19 durch eine der Seitenflächen des Trägers 3 gebildet. Abgesehen von dieser Fläche ist das Bauelement vorzugsweise allseitig und besonders bevorzugt vollflächig verspiegelt. Strahlung 20 kann über die Auskoppelfläche aus dem Bauelement austreten.

Das Bauelement gemäß Figur 1 ist als seitlich emittierendes Bauelement (Side-Looker) ausgebildet, welches Strahlung über eine Auskoppelfläche 19, welche quer zum aktiven Bereich verläuft, emittiert. Die Strahlung 20 kann insbesondere parallel zum aktiven Bereich aus dem Bauelement auskoppeln. Side-Looker-Bauelemente sind für die Hinterleuchtung von Anzeigevorrichtungen, z.B. Flüssigkristallanzeigen, oder zur Einkopplung von Strahlung in einen Wellenleiter besonders geeignet.

Da die Anschlussflächen 70, 80 auf einer gemeinsamen Seite des Bauelements 1 vorgesehen sind, sind die Freiheitsgrade bei der Auswahl der unverspiegelten Auskoppelfläche vorteilhaft erhöht. Die Auskoppelfläche kann durch einfaches Nichtverspiegeln der jeweiligen Fläche ausgebildet werden.

Auf die Auskoppelfläche 19 kann ein weiteres Element aufgebracht sein (nicht explizit dargestellt). Beispielsweise kann eine Lumineszenzkonversionsschicht mit einem Konversionsstoff auf die Auskoppelfläche aufgebracht sein. Diese Schicht kann im aktiven Bereich erzeugte Strahlung absorbieren und in Strahlung einer größeren Wellenlänge umwandeln. Die beiden Strahlungen können sich mischen, so dass auf der der Lumineszenzkonversionsschicht abgewandten Seite des Bauelements Strahlung mit einer Mischfarbe, z.B. weißes Licht, abgestrahlt wird. Geeignete Konversionsstoffe sind beispielsweise in der Druckschrift WO 98/12757 beschrieben. Alternativ oder ergänzend kann auf die Auskoppelfläche ein optisches Element, z.B. ein refraktives Element zur Strahlformung, insbesondere eine Linse, oder ein diffraktives Element, angeordnet und insbesondere auf das Bauelement aufgebracht sein. Weiterhin kann seitens der Auskoppelfläche eine photonische Kristallstruktur angeordnet sein.

Ein derartiges Bauelement 1 kann im Verbund hergestellt werden, wobei gleichzeitig eine Mehrzahl derartiger Bauelement erhalten werden kann. Die Verbundfertigung ist daher besonders kostengünstig.

Ein für die Verbundfertigung geeignetes Verfahren für die Herstellung einer Mehrzahl von optoelektronischen Bauelementen ist in der WO 2005/081319 beschrieben.

Gegenüber herkömmlichen Opto-Bauteilen, die einen Halbleiterchip zur Strahlungserzeugung umfassen, der in einem den Chip schützenden Gehäuse oder auf einem Leiterrahmen montiert ist, wobei die Chips dieser Bauteile nach der Montage für jedes Bauteil einzeln und nicht verbundmäßig verkapselt werden, können die hierin beschriebenen Bauelemente komplett im Verbund hergestellt werden.

Auf eine nachträgliche Verkapselung der Bauelemente zum Schutz derselben nach dem Vereinzeln von Bauelementen aus dem Verbund kann verzichtet werden.

Eine schützende Verkapselung 40 kann vielmehr bereits im Verbund vorgesehen werden. Eine Verkapselung ist in Figur 1 gestrichelt angedeutet. Der Halbleiterkörper ist zweckmäßigerweise in die Verkapselung eingebettet. Die Verkapselung 40 ist Teil des vereinzelten Bauelements. Die Verkapselung 40 kann vereinzelte Aussenflächen 41 aufweisen. Die Verkapselung 40 schützt den aktiven Bereich 4 bevorzugt vor schädlichen äußeren Einflüssen, wie z.B. Feuchtigkeit.

Für die Verkapselung kann eine Formmasse, z.B. BCB, auf den Halbleiterkörper aufgebracht sein. Diese wird zweckmäßigerweise nachfolgend gehärtet. Die gehärtete Verkapselung ist mechanisch stabil und schützt den aktiven Bereich effizient. Die Verkapselung 40 kann den Halbleiterkörper 2 umgreifen. Der Halbleiterkörper wird durch die Verkapselung vorzugsweise in Zusammenwirken mit dem Träger geschützt. Die Verkapselung 40 erstreckt sich bevorzugt entlang aller nicht dem Träger 3 zugewandten Seiten des Halbleiterkörpers 2, wobei die Anschlussflächen 70, 80 auf der dem Halbleiterkörper 2 abgewandten Seite der Verkapselung 40 vorzugsweise freiliegen.

Nitrid-Verbindungshalbleiter sind besonders widerstandsfähig gegen äußere Einflüsse, so dass auf eine Verkapselung bei einem Nitrid-basierten Bauelement vergleichsweise risikolos verzichtet werden kann.

Phosphid- und Arsenid-Verbindungshalbleiter sind demgegenüber, insbesondere falls sie Al enthalten, empfindlicher, z. B. im Hinblick auf Feuchtigkeit. Das Vorsehen einer Verkapselung ist bei Bauelementen, deren Halbleiterkörper eines dieser Materialien enthält, daher von besonderem Vorteil.

Das Verhältnis des Flächeninhalts der vom Halbleiterkörper 2 überdeckten Fläche in Aufsicht auf die Anschlussseite zu dem Inhalt der gesamten Fläche, über die sich das Bauelement 1 in Aufsicht auf die Anschlussseite erstreckt, kann größer als 0,2, bevorzugt größer als 0,3, besonders bevorzugt größer als 0,5, am meisten bevorzugt größer als 0,7 sein.

Um den Strahlungsaustritt aus dem Halbleiterkörper, insbesondere den Strahlungsübertritt von dem Halbleiterkörper 2 in den Träger 3, zu erleichtern, kann die der Anschlussseite abgewandte Oberfläche des Halbleiterkörpers 2, insbesondere die dem Träger zugewandte Oberfläche des Halbleiterkörpers 2, eine Oberflächenstruktur 21 mit Erhebungen und Vertiefungen aufweisen. Eine derartige Struktur kann beispielsweise durch Aufrauen dieser Oberfläche des Halbleiterkörpers, z.B. durch Ätzen, oder, insbesondere falls der Träger aus dem Aufwachssubstrat gebildet ist, durch den gezielten Einsatz eines unebenen Aufwachssubstrats erzielt werden. Über ein unebenes Aufwachssubstrat kann gezielt eine Versetzungsbildung in den epitaxierten substratseitigen Halbleiterschichten herbeigeführt werden, wobei aufgrund der Versetzungen eine unebene Oberfläche gebildet wird. Eine derartige Oberflächenstruktur 21 ist in der stark vereinfachten Schnittansicht in Figur 1D schematisch dargestellt.

Durch eine derartige Oberflächenstruktur 21 kann eine Reflexion, z. B. Totalreflexion, an der Grenzfläche zwischen Halbleiterkörper und Träger gestört werden. Der Übertritt von Strahlung vom Halbleiterkörper 2 in den Träger 3 wird so erleichtert. Wird beispielsweise bei einem Nitrid-Verbindungshalbleiter-Halbleiterkörper ein Saphir-Träger, der vorzugsweise aus dem Aufwachssubstrat gefertigt ist, eingesetzt, so weist dieser einen geringeren Brechungsindex als das Nitrid-Verbindungshalbleitermaterial auf, sodass die Gefahr fortgesetzter Totalreflexion im Halbleiterkörper besteht. Diese Totalreflexion kann durch die Oberflächenstruktur 21 gestört werden.

Bevorzugt ist (sind) Ausnehmung(en) 11, in der (denen) sich der zweite Kontakt 8 erstreckt, angeschrägt ausgebildet. Eine derart angeschrägte Ausbildung ist in der Teilschnittansicht in Figur 1E schematisch skizziert. Über Reflexion von Strahlung an dem in der Ausnehmung angeordneten Kontaktmaterial kann der Strahlengang im Halbleiterkörper gestört werden. Die aus dem Halbleiterkörper in den Träger übertretende Strahlungsleistung kann hierüber erhöht werden. Vorzugsweise verjüngt sich die Ausnehmung ausgehend von der Anschlussseite des Bauelements in Richtung der der Anschlussseite abgewandten Seite des aktiven Bereichs. Eine derartige Formgebung kann beispielsweise durch Ausbilden der Ausnehmung über Trockenätzen mit einer entsprechend angeschrägten Maske erzielt werden.

Bevorzugt weist die Auskoppelfläche 19 Erhebungen und Vertiefungen auf. Mittels einer derartigen Auskoppelstruktur kann die über die Auskoppelfläche austretende Strahlungsleistung aufgrund gestörter (Total)Reflexion an der Auskoppelfläche erhöht werden. Eine solche Auskoppelstruktur ist in den Figuren 1B und 1C gestrichelt angedeutet.

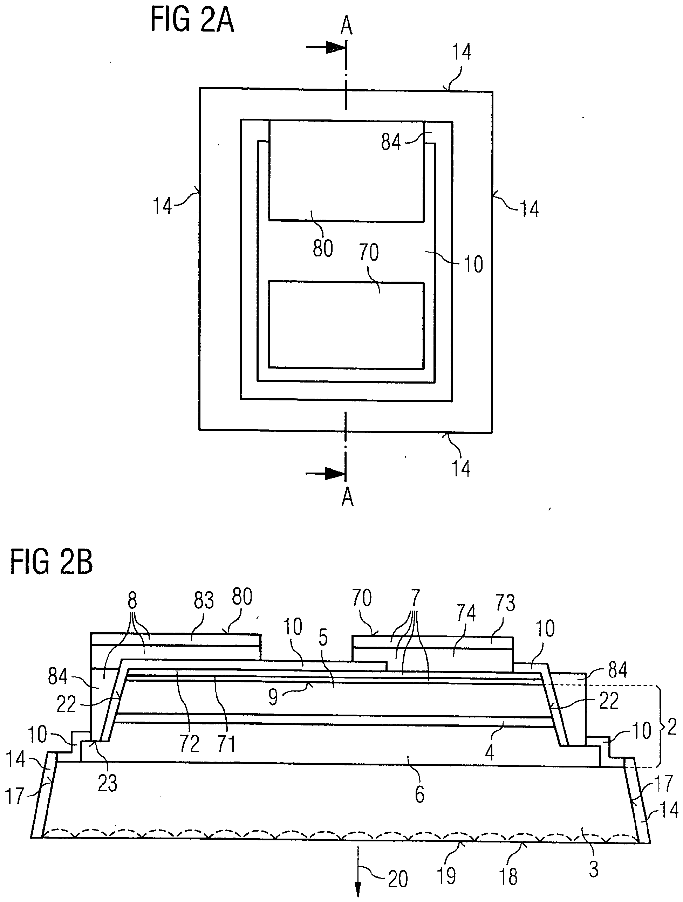

Figur 2 zeigt ein anderes Beispiel eines optoelektronischen Bauelements anhand einer schematischen Aufsicht in Figur 2A und einer schematischen Schnittansicht in Figur 2B. Der Schnitt in Figur 2B ist dabei entlang der Linie A-A in Figur 2A genommen. Im Wesentlichen entspricht das Beispiel gemäß Figur 2 dem im Zusammenhang mit Figur 1 beschriebenen Ausführungsbeispiel.

Im Unterschied dazu erfolgt die elektrische Kontaktierung der von der Anschlussseite abgewandten Seite des Halbleiterkörpers, insbesondere die Kontaktierung des Bereichs 6 des Halbleiterkörpers 2, lateral neben einer den Halbleiterkörper 2 lateral begrenzenden Seitenfläche 22. Auf Ausnehmungen und Kontaktfortsätze gemäß dem Ausführungsbeispiel in Figur 1 und dementsprechend auch auf eine zweite Isolationsschicht 13 kann so verzichtet werden. Die Kontaktschicht 71 und vorzugsweise die Reflektorschicht 72 kann so als durchgehende Schicht ausgeführt sein.

Der zweite Kontakt 8 erstreckt sich neben einer den aktiven Bereich 4 begrenzenden Seitenfläche 22 des Halbleiterkörpers von der Anschlussseite ausgehend bis zu der der Anschlussseite abgewandten Seite des aktiven Bereichs 4. Der zweite Kontakt 8 weist hierzu vorzugsweise eine neben dem aktiven Bereich verlaufende und sich über diesen hinweg erstreckende, vorzugsweise auf der Isolationsschicht 10 abgeschiedene, Schicht 84 auf. Diese Schicht 84 ist in einem Kontaktbereich 23 auf der von der Anschlussseite abgewandten Seite des aktiven Bereichs 4 elektrisch leitend mit dem Halbleiterkörper, insbesondere dem Bereich 6, verbunden. Vorzugsweise umläuft die Schicht 84 den Halbleiterkörper rahmenartig. Eine homogene Ladungsträgerinjektion über den aktiven Bereich 4 zur großflächigen Strahlungserzeugung kann so erleichtert werden.

Weiterhin sind die Seitenflächen 22 des Halbleiterkörpers angeschrägt ausgeführt. Durch Reflexion an der dem Halbleiterkörper zugewandten und schräg verlaufenden Oberfläche der Schicht 84 des zweiten Kontakts 8 kann der Strahlengang im Halbleiterkörper gestört werden. Hierdurch kann die in den Träger 3 tretende Strahlungsleistung erhöht werden.

Im Gegensatz zum Ausführungsbeispiel gemäß Figur 1 sind alle Seitenflächen 17 des Trägers 3 verspiegelt und insbesondere mit der Spiegelschicht 14 versehen. Die dem Halbleiterkörper 2 abgewandte Oberfläche 18 des Trägers 3 ist als unverspiegelte Auskoppelfläche 19 ausgebildet. Das Bauelement ist also als Top-Looker ausgeführt. Die Auskoppelfläche 19 kann eine Oberflächenstruktur aufweisen, welche durch die gestrichelte Linienführung angedeutet ist. Selbstverständlich können bei entsprechender Ausbildung der Verspiegelung das Bauelement gemäß Figur 1 als Top-Looker und das Bauelement gemäß Figur 2 als Side-Looker ausgebildet werden.

Entsprechend der Darstellung in Figur 2 angeschrägte Seitenflächen des Halbleiterkörpers 2 und/oder des Trägers 3 können selbstverständlich auch beim Bauelement gemäß Figur 1 vorgesehen sein.

Das Bauelement 1 gemäß Figur 2 kann auch mit einer Verkapselung 40 versehen sein, wie sie in den Figuren 1B und 1C angedeutet ist. Weiterhin kann die dem Träger 3 zugewandte Seite des Halbleiterkörpers 2 eine Struktur gemäß Figur 1D aufweisen.

Die chipartigen Bauelemente gemäß den Figuren 1 und 2 eignen sich besonders zur Hinterleuchtung einer Anzeigevorrichtung, z.B. einer Flüssigkristallanzeigevorrichtung, oder zur Einkopplung von Strahlung in einen Wellenleiter.

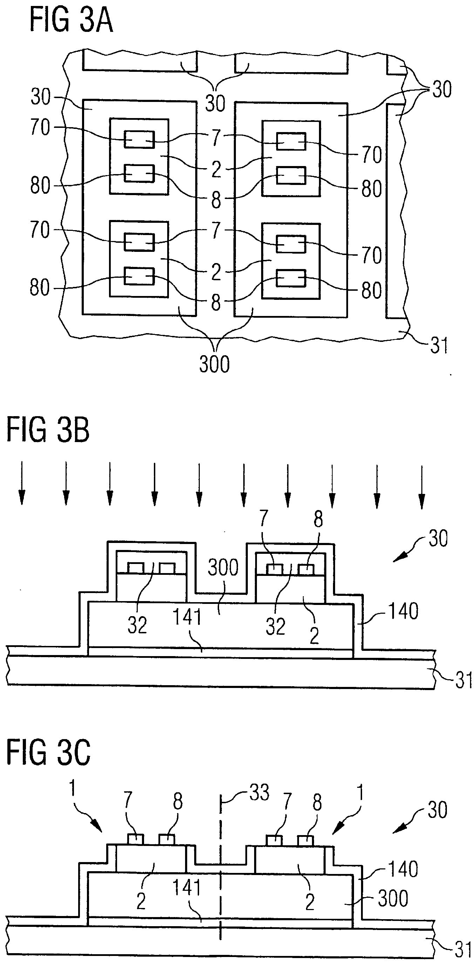

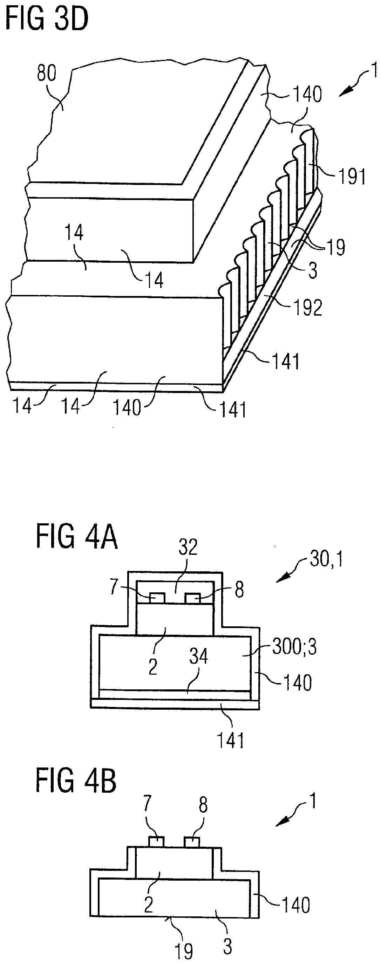

Figur 3 zeigt ein Ausführungsbeispiel für ein Verfahren zur Herstellung einer Mehrzahl von optoelektronischen Bauelementen anhand der in den Figuren 3A bis 3D schematisch dargestellten Zwischenschritte.

Zunächst wird, wie in Figur 3A anhand einer Aufsicht schematisch dargestellt, eine Mehrzahl von, insbesondere gleichartigen, Verbundelementen 30 bereitgestellt. Die Verbundelemente 30 sind nebeneinander auf einem Hilfsträger 31 angeordnet. In Figur 3 ist jeweils lediglich ein Ausschnitt der Anordnung der Verbundelemente 30 auf dem Hilfsträger 31 dargestellt.

Ein einzelnes Verbundelement umfasst dabei jeweils eine Trägerschicht 300. Auf der Trägerschicht 300 ist jeweils eine Mehrzahl von Halbleiterkörpern 2 angeordnet. Die Halbleiterkörper sind vorzugsweise gemäß den im Zusammenhang mit den Figuren 1 und 2 beschriebenen Halbleiterkörpern ausgebildet. Es kann insbesondere bereits eine Kontaktstruktur mit zwei anschlussseitig elektrisch voneinander isolierten Kontakten 7, 8, die mit dem aktiven Bereich des Halbleiterkörpers elektrisch leitend verbunden sind, vorgesehen sein. Aus Übersichtlichkeitsgründen ist sowohl der Verlauf der Kontaktstruktur als auch der aktive Bereich nicht näher dargestellt. Die Anschlussflächen 70 und 80 der Kontakte 7 und 8 sind auf der von der Trägerschicht 300 abgewandten Seite des Halbleiterkörpers 2 angeordnet.

Die Verbundelemente 30 können beispielsweise durch Vereinzeln eines Ausgangsverbundes erhalten sein. Der Ausgangsverbund kann durch einen Halbleiterwafer, der ein Aufwachssubstrat und eine auf diesem Substrat epitaktisch gewachsene Halbleiterschichtstruktur umfasst, ausgebildet sein. Aus der Halbleiterschichtstruktur können die Halbleiterkörper 2 strukturiert sein. Die Kontakte 7, 8 für die Halbleiterkörper 2 können noch im Ausgangsverbund vorgesehen werden.

Der Ausgangsverbund kann nach dem Ausbilden der Halbleiterkörper und vorzugsweise nach dem Ausbilden der Kontakte in Verbundelemente 30 vereinzelt werden. Ist die Trägerschicht 300 vom Aufwachssubstrat der Halbleiterschichtstruktur verschieden, so kann zunächst eine Schicht für die Trägerschichten der Verbundelemente auf den Ausgangsverbund aufgebracht werden, nachfolgend das Aufwachssubstrat abgelöst werden und daraufhin durch die Schicht für die Trägerschichten in Verbundelemente 30 vereinzelt werden. Der Verbundelemente-Hilfsträger-Verbund wird zweckmäßigerweise beim Vereinzeln des Ausgangsverbundes gebildet, wobei der Hilfsträger diesen Verbund mit Vorteil mechanisch stabilisiert. Auf dem Hilfsträger 31 kann eine Vielzahl von Verbundelementen 30, z. B. 50 Verbundelemente oder mehr oder 100 Verbundelemente oder mehr, angeordnet sein.

Die Verbundelemente 30 umfassen jeweils bevorzugt eine Mehrzahl von einzeilig nebeneinander angeordneten Halbleiterkörpern 2. Besonders bevorzugt umfasst ein Verbundelement genau zwei Halbleiterkörper.

Nachfolgend werden die Verbundelemente 30 verspiegelt. Bevorzugt wird vor der Verspiegelung auf nicht unmittelbar zu verspiegelnde Teilbereiche des jeweiligen Verbundelements, z. B. die Anschlussseite des jeweiligen Halbleiterkörpers 2, eine Schutzschicht 32 aufgebracht. Die Schutzschicht 32 ist vorzugsweise derart strukturiert, dass die Bereiche des Verbundelements, die nicht unmittelbar verspiegelt werden sollen, mit der Schutzschicht versehen sind. Für eine derartige Schutzschicht eignet sich beispielsweise ein photostrukturierbares Material, wie etwa ein Photolack.

Nach dem Vorsehen der Schutzschicht 32, die vorzugsweise alle freiliegenden Bereiche der Kontakte 7 und 8 bedeckt, können die Verbundelemente 30 mit einer Spiegelschicht 140 versehen werden. Diese Spiegelschicht 140 wird vorzugsweise auf die Verbundelemente abgeschieden. Dabei kann auch der Hilfsträger 31 in nicht mit Verbundelementen 30 belegten Bereichen verspiegelt werden. Das Aufbringen der Spiegelschicht wird durch die Pfeile in Figur 3B angedeutet. Die Verbundelemente 30 werden auf den nicht dem Hilfsträger 31 zugewandten Seiten vorzugsweise vollflächig verspiegelt.

Um eine Verspiegelung von Seitenflächen der Verbundelemente zu erleichtern, ist der Hilfsträger vorzugsweise dehnbar ausgebildet. Vor dem Aufbringen der Spiegelschicht kann der Hilfsträger expandiert werden, so dass sich Zwischenräume zwischen benachbarten Verbundelementen vergrößern. Die jeweiligen Seitenflächen der Verbundelemente können dann vereinfacht mit Spiegelschichtmaterial bedeckt werden. Die Spiegelschicht kann beispielsweise als Spiegelmetallisierung oder als Kaltlichtspiegel ausgeführt sein oder eine Spiegelmetallisierung und einen Kaltlichtspiegel aufweisen. Als dehnbarer Hilfsträger eignet sich besonders eine dehnbare Folie. Derartige Folien können als Säge-Folien beispielsweise von Hitachi erworben werden.

Die dem Hilfsträger 31 zugewandte und gegenüber dem Aufbringen des Spiegelschichtmaterials auf die Verbundelemente abgeschattete Seite des jeweiligen Verbundelements 30 kann bereits zuvor, z. B. noch im Ausgangsverbund, mit einer weiteren Spiegelschicht 141 versehen worden sein. Ist die von den Halbleiterkörpern 2 abgewandte Seite der Trägerschicht für das Ausbilden einer Auskoppelfläche des herzustellenden optoelektronischen Bauelements vorgesehen, so kann auf eine Verspiegelung dieser Fläche und dementsprechend die Spiegelschicht 141 verzichtet werden. Die nach dem Verspiegeln der Verbundelemente resultierende Struktur ist in Figur 3B anhand einer schematischen Teilschnittansicht dargestellt.

Nachfolgend kann die Schutzschicht 32 zusammen mit dem auf ihr angeordneten Teilbereich der Spiegelschicht wieder entfernt werden. Hierdurch werden die Kontakte 7 und 8 wieder freigelegt. Auf die Schutzschicht 32 kann verzichtet werden, wenn die Anschlussflächen der Kontakte dem Hilfsträger 31 zugewandt sind (nicht explizit dargestellt). Die dem Hilfsträger zugewandte Seite ist gegenüber dem Abscheiden der Spiegelschicht abgeschattet. Hierüber kann ohne gesonderte Schutzschicht verhindert werden, dass Spiegelmaterial unmittelbar auf die Kontakte gelangt. Die Gefahr eines Kurzschlusses wird in der Folge verringert.

Daraufhin können die Verbundelemente 30 in Bauelemente 1 vereinzelt werden. Die Vereinzelung kann durch Zertrennen der Verbundelemente in einem Bereich zwischen zwei benachbarten Halbleiterkörpern 2 erfolgen. Beispielsweise kann entlang der Linie 33 in Figur 3C vereinzelt werden. Dabei wird die Spiegelschicht 140 durchtrennt. Auch die Trägerschicht 300 wird beim Vereinzeln durchtrennt. Im durchtrennten Bereich, der nach dem Verspiegeln freigelegt ist, ist der aus der Trägerschicht 300 hervorgehende Träger 3 unverspiegelt. Gegebenenfalls wird auch die auf der den Halbleiterkörpern 2 abgewandten Seite der Trägerschicht 300 angeordnete Spiegelschicht 141, soweit eine solche vorgesehen ist, durchtrennt. Die vereinzelten Bauelemente können von dem Hilfsträger 31 abgehoben werden.

Das Verbundelement, insbesondere die Trägerschicht 300 kann zum Vereinzeln beispielsweise zunächst angeritzt, z.B. mittels eines Lasers, und nachfolgend im angeritzten Bereich gebrochen werden.

Wird ein Verbundelement 30 gemäß Figur 3C vereinzelt, so entstehen zwei Side-Looker-Bauelemente mit unverspiegelten und insbesondere einander zugewandten Auskoppelflächen. Die Bauelemente 1 weisen jeweils eine vereinzelte Auskoppelfläche auf und sind beispielsweise gemäß Figur 1 ausgebildet. Eine Teilaufsicht auf ein Bauelement 1 nach dem Vereinzeln ist in Figur 3D dargestellt. Wird durch Ritzen und anschließendes Brechen vereinzelt, so weist die Auskoppelfläche, insbesondere seitens des Halbleiterkörpers 2, einen strukturierten Bereich 191 und, insbesondere in dem weiter vom Halbleiterkörper entfernten Bereich, einen im Vergleich zu dem strukturierten Bereich ebenen, vorzugsweise gebrochenen, Bereich 192 auf. Beim Vereinzeln kann also eine Auskoppelstruktur in der Auskoppelfläche 19 erzeugt werden. Mittels dieser Struktur kann die über diese Fläche ausgekoppelte Strahlungsleistung erhöht werden. Die Verspiegelung 14 weist dabei Teile der Spiegelschichten 141 und 140 auf, welche beim Vereinzeln des Verbundelements erhalten werden.

Der Träger 3 des Bauelements 1 geht beim Vereinzeln aus der Trägerschicht 300 hervor. Beim Vereinzeln des Verbundelements 30 können somit gleichzeitig zwei seitlich emittierende Bauelemente (Side-Looker), insbesondere Bauelemente mit einander zugewandten Auskoppelflächen 19, gebildet werden.

Soll ein oberflächenemittierendes Bauelement, insbesondere ein Top-Looker, mit der dem Halbleiterkörper 2 abgewandten Fläche des Trägers 3 als Auskoppelfläche ausgebildet werden, so wird zweckmäßigerweise auf die Spiegelschicht 141 verzichtet. Eine beim Vereinzeln ausgebildete unverspiegelte Seitenfläche des Trägers 3 kann für den Top-Looker gegebenenfalls nachfolgend - eventuell unter Expansion des Hilfsträgers 31 - verspiegelt werden.

Alternativ kann ein Bauelement 1 zunächst vollflächig und gegebenenfalls bis auf eine abgeschattete Seite allseitig verspiegelt werden und die für das Ausbilden einer Auskoppelfläche vorgesehene Fläche kann nachfolgend von der Spiegelschicht befreit werden. Für das Befreien der für die Auskoppelfläche vorgesehenen Fläche können für die Auskoppelflächen vorgesehene Bereiche des Verbundelements 30 mit einer gegebenenfalls weiteren Schutzschicht 34 versehen werden. Daraufhin kann verspiegelt werden und die verspiegelte Schutzschicht 34 kann, gegebenenfalls zusammen mit der Schutzschicht 32, welche mit Vorzug die Kontakte 7 und 8 bedeckt, nachfolgend entfernt werden. Dabei kann die Auskoppelfläche freigelegt werden. Das Verbundelement 30 kann vor oder nach dem Entfernen der verspiegelten Schutzschicht vereinzelt werden. Auf die Schutzschicht 32 kann verzichtet werden, wenn die Anschlussflächen der Kontakte dem Hilfsträger 31 zugewandt sind (nicht explizit dargestellt). Die dem Hilfsträger zugewandte Seite ist gegenüber dem Abscheiden der Spiegelschicht abgeschattet. Hierüber kann ohne gesonderte Schutzschicht verhindert werden, dass Spiegelmaterial unmittelbar auf die Kontakte gelangt. Die Gefahr eines Kurzschlusses wird in der Folge verringert.

Die Schutzschicht 34 kann in fließfähigem Zustand auf den Verbund aufgebracht werden und nach dem Aufbringen gegebenenfalls, zum Beispiel thermisch, gehärtet werden. Beispielsweise kann die Schutzschicht einen Polyvenylalkohol (kurz: PVA) enthalten. Eine PVA-Schutzschicht ist thermisch härtbar. Weiterhin wird mit Vorzug eine lösliche, z.B. wasserlösliche, Schutzschicht vorgesehen. Die Schutzzschicht kann dann auf einfache Weise abgespült werden. PVA ist wasserlöslich.

Ein derartiges Verfahren ist anhand der Zwischenschritte in den schematischen Schnittansichten in den Figuren 4A und 4B dargestellt, wobei Figur 4A die Situation nach dem Verspiegeln und Figur 4B die Situation nach dem Entfernen der verspiegelten Schutzschicht(en) zeigt. Auf diese Weise kann beispielsweise ein Bauelement gemäß Figur 2 hergestellt werden.

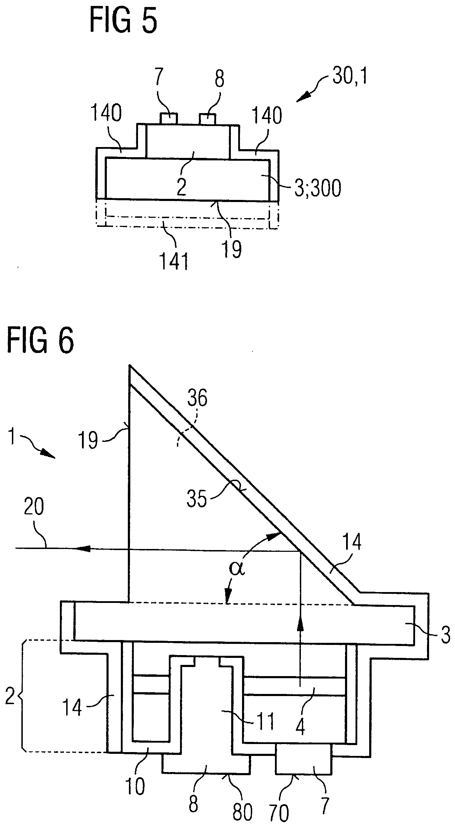

Alternativ zum Vorsehen einer Schutzschicht kann die Spiegelschicht von einer verspiegelten Auskoppelfläche auch unter mechanischer Belastung entfernt werden. Dies ist in Figur 5 schematisch angedeutet. Hierzu kann die Trägerschicht 300 des Verbundelements 30 oder der Träger 3 des bereits vereinzelten Bauelements 1 von der dem Halbleiterkörper 2 abgewandten Seite her abgeschliffen werden, wodurch eine Verspiegelung 141 der dem Halbleiterkörper abgewandten Seite der Trägerschicht 300 bzw. des Trägers 3 entfernt wird. Hierbei kann insbesondere auch ein Teil des Trägers 3 bzw. der Trägerschicht 300 abgetragen werden.

Der Träger 3 eines Bauelements 1 kann gedünnt sein.

Figur 6 zeigt ein weiteres Ausführungsbeispiel eines optoelektronischen Bauelements 1 anhand einer schematischen Schnittansicht. Das Bauelement 1 ist als Side-Looker-Bauelement ausgebildet. Im Wesentlichen entspricht das Bauelement 1 dem im Zusammenhang mit Figur 1 beschriebenen Bauelement, wobei auf die Kontaktschicht verzichtet sein kann. Eine Kontaktstruktur gemäß Figur 1 ist aufgrund der bereits oben genannten Vorteile jedoch bevorzugt, in Figur 6 aber aus Übersichtlichkeitsgründen nicht explizit dargestellt. Weiterhin kann die Kontaktierung des Bauelements alternativ auch gemäß dem im Zusammenhang mit Figur 2 beschriebenen Bauelement ausgeführt sein.

Im Unterschied zu den oben beschriebenen Bauelementen weist das Bauelement gemäß Figur 6 eine sich, vorzugsweise vollständig, über den aktiven Bereich 4 erstreckende Reflektorfläche 35 auf, welche schräg, also unter einem von 90° verschiedenen, vorzugsweise spitzen Winkel α, bezüglich des aktiven Bereichs 4 verläuft. Ein Winkel von 45° oder weniger hat sich als besonders vorteilhaft erwiesen. Beispielsweise beträgt der Winkel α 45°. Vorzugsweise ist die Reflektorfläche 35 verspiegelt und hierzu mit der Spiegelschicht 14 versehen.

Die Reflektorfläche 35 kann durch entsprechende Strukturierung des Trägers 3 bzw. der Trägerschicht 300 im Verbundelement ausgebildet sein. Alternativ kann ein strahlungsdurchlässiges teilverspiegeltes Auskoppelfenster 36 mit dem Träger 3 verbunden sein. Dies ist durch die gestrichelte Linienführung angedeutet. Das Auskoppelfenster 36 ist vorzugsweise mechanisch stabil mit dem Träger 3 verbunden, beispielsweise verklebt. Vorzugsweise wird hierbei ein unter dem Einfluss kurzwelliger Strahlung, z. B. ultravioletter oder blauer Strahlung, stabiles Material für das Auskoppelfenster 36 und/oder eine Befestigungsschicht zwischen dem Träger 3 und dem Auskoppelfenster 36 eingesetzt. Beispielsweise enthält das Auskoppelfenster hierzu ein Glas oder ein polymeres Material, z.B. BCB.

Der Einsatz von gegenüber hochenergetischer Strahlung beständiger Materialien für das Auskoppelfenster ist besonders bei einem Halbleiterkörper aus Nitrid-Verbindungshalbleitermaterial zweckmäßig, in dem hochenergetische kurzwellige, z.B. blaue oder ultraviolette, Strahlung erzeugt werden kann.

Über die schräge Reflektorfläche 35 kann Strahlung gezielter auf die Auskoppelfläche 19 gerichtet werden. Für die schräge Reflektorfläche 35 ist ein keilartig geformter Körper besonders zweckmäßig. Dementsprechend wird z.B. der Träger 3 in einem Bereich mit einer keilartigen Struktur versehen oder ein keilartig geformtes Auskoppelfenster 36 eingesetzt.

Die Auskoppelfläche 19 erstreckt sich über die Reflektorfläche 35, vorzugsweise über die gesamte Reflektorfläche 35. Die Reflektorfläche und die Auskoppelfläche verlaufen schräg, insbesondere unter einem von 90° verschiedenen Winkel, z.B. 45°, zueinander. Weiterhin verläuft die Auskoppelfläche mit Vorzug senkrecht zum aktiven Bereich.

Vorzugsweise wird die schräge Reflektorfläche 35 im Verbund ausgebildet. Ein Fensterverbund mit einer Mehrzahl von vorgeformten Auskoppelfensterbereichen kann hierfür auf den Verbundelementen befestigt oder bereits im Ausgangsverbund vorgesehen werden.

Das Auskoppelfenster 36 kann gegebenenfalls auch direkt auf den Halbleiterkörper 2 aufgebracht werden. Der Träger 3, z.B. das Auswachssubstrat, kann dementsprechend entfernt sein. Die Bauhöhe des Bauelements verringert sich hierdurch dementsprechend.

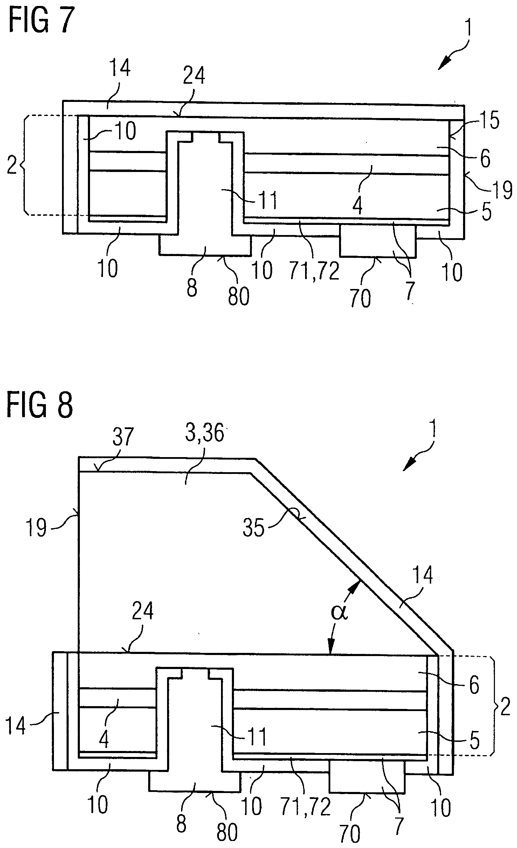

Figur 7 zeigt ein weiteres Ausführungsbeispiel eines optoelektronischen Bauelements 1 anhand einer schematischen Schnittansicht. Im wesentlichen entspricht das Bauelement 1 dem im Zusammenhang mit Figur 1 beschriebenen Bauelement. Im Unterschied hierzu ist auf einen Träger, der den Halbleiterkörper 2 mechanisch stabilisiert, verzichtet. Die Auskoppelfläche 19 des Bauelements 1 erstreckt sich über den aktiven Bereich 4 und verläuft quer zum aktiven Bereich. Die Auskoppelfläche 19 kann lateral neben der den aktiven Bereich 4 begrenzenden Seitenfläche 15 des Halbleiterkörpers 2 angeordnet sein. Die Auskoppelfläche kann beispielsweise durch die vom Halbleiterkörper abgewandte Seite der Isolationsschicht 10 gebildet sein. Gegebenenfalls kann auch die Seitenfläche 15 des Halbleiterkörpers unmittelbar die Auskoppelfläche bilden. In diesem Falle ist der Halbleiterkörper seitens der Seitenfläche 15 zweckmäßigerweise frei von der Isolationsschicht 10.

Das in Figur 7 dargestellte Bauelement, beispielsweise eine Lümineszenzdiode, ist frei von einem gesondert vorgesehenen, den Halbleiterkörper, der bevorzugt epitaktisch gewachsen ist, stabilisierenden Element. Insbesondere ist auf den Träger 3 verzichtet.

Dieses trägerlose Bauelement zeichnet sich durch eine besonders geringe Bauhöhe aus. Das Bauelement besteht aus dem Halbleiterkörper 2, den Kontakten 7, 8 und darauf aufgebrachten, insbesondere abgeschiedenen, Schichten, die mit Vorzug jeweils nicht selbsttragend ausgebildet sind.

Die den Anschlussflächen der Kontakte abgewandte Oberfläche 24 des Halbleiterkörpers 2 ist, insbesondere unmittelbar, mit der Spiegelschicht 14 versehen.

Abgesehen von der Auskoppelfläche 19 und der Anschlussseite ist das Bauelement mit der Spiegelschicht 14 versehen. Über die Reflektorschicht 72 des Kontakts 7 kann auch seitens der Anschlussflächen 70, 80 eine Reflexion von Strahlung zurück in den Halbleiterkörper 2 erzielt werden. Seitens der Auskoppelfläche 19 wird dementsprechend eine besonders hohe spezifische Ausstrahlung erzielt.

Abgesehen von der Auskoppelfläche sind alle Oberflächen des Bauelements mit einem Reflexionselement - der Verspiegelung 14 oder der Reflektorschicht 72 - versehen.

Selbstverständlich kann ein derartiges trägerloses Bauelement nicht nur, wie dargestellt, als Side-Looker ausgeführt sein, sondern bei geeigneter Ausbildung der Verspiegelung auch als Top-Looker Bauelement ausgebildet werden. In diesem Fall bleibt eine den Anschlussflächen 70, 80 der Kontakte 7, 8 abgewandte Oberfläche des Halbleiterkörpers, insbesondere die Oberfläche 24, in einem Teilbereich oder vollständig unverspiegelt. Die in Figur 7 spiegelfreie Seitenfläche 15 des Halbleiterkörpers wird in diesem Falle bevorzugt mit einer Spiegelschicht versehen (nicht explizit dargestellt). Für einen Top-Looker ist die Oberfläche 24 des Halbleiterkörpers zweckmäßigerweise mit einer Oberflächenstruktur 21, beispielsweise gemäß der in Figur 1D gezeigten Oberflächenstruktur versehen.

Ein Träger 3 beziehungsweise eine Trägerschicht 300 kann als temporärer Zwischenträger während der Herstellung eines derart trägerlosen, insbesondere aufwachssubstratlosen, Bauelements 1 vorgesehen sein. Der Träger 3 beziehungsweise die Trägerschicht 300 wird jedoch während des Herstellungsverfahrens entfernt. Vorzugsweise wird der Träger 3 beziehungsweise die Trägerschicht 300 vollständig entfernt.

Für die Herstellung eines derartigen trägerlosen Bauelements ist es besonders zweckmäßig, Verbundelemente 30, wie weiter oben beschrieben, oder bereits aus dem Verbundelemente vereinzelte Teile derart auf dem Hilfsträger 31 anzuordnen, dass die Anschlussflächen 70, 80 der Kontakte dem Hilfsträger 31 zugewandt sind. Daraufhin kann die Trägerschicht 300 beziehungsweise ein bereits vereinzelter Träger 3, z. B. durch ein Laser-gestütztes Verfahren, von den Halbleiterkörpern 3 entfernt werden. Nach dem Entfernen kann dann bis auf die abgeschattete Seite vollflächig verspiegelt werden. Dabei wird mit Vorzug eine nicht unmittelbar zu verspiegelnde Auskoppelfläche des herzustellenden Bauelements mit einer geeigneten Schutzschicht bedeckt, welche nach dem Verspiegeln, zusammen mit der auf der Schutzschicht aufgebrachten Spiegelschicht wieder vom Bauelement entfernt wird, so dass eine Auskoppelfläche entsteht.

Auch die anderen der weiter oben und im Folgenden beschriebenen Bauelemente können gegebenenfalls als trägerlose Bauelemente ausgeführt sein.

Figur 8 zeigt ein weiteres Ausführungsbeispiel eines optoelektronischen Bauelements 1 anhand einer schematischen Schnittansicht. Im wesentlichen entspricht das Bauelement dem im Zusammenhang mit Figur 6 beschriebenen Bauelement. Insbesondere weist das Bauelement eine sich schräg zum aktiven Bereich erstreckende Reflektorfläche 35 auf. Diese kann in einem gesonderten Auskoppelfenster 36 oder dem Träger 3 vorgesehen sein. Im Unterschied zum in Figur 6 gezeigten Bauelement ist der Träger 3 beziehungsweise das Auskoppelfenster 36 auf der vom Halbleiterkörper 2 abgewandten Seite in einem Teilbereich 37 abgeflacht. Dieser Bereich 37 ist zweckmäßigerweise verspiegelt. Der Teilbereich 37 verläuft bevorzugt parallel zum aktiven Bereich.

Die Reflektorfläche 35 erstreckt sich vorzugsweise von dem abgeflachten Teilbereich 37 ausgehend schräg zum aktiven Bereich in Richtung des Halbleiterkörpers. Vorzugsweise verläuft die Reflektorfläche 35 schräg zu der von den Anschlussflächen 70, 80 der Kontakte 7, 8 abgewandten Oberfläche 24 des Halbleiterkörpers 2. Die Reflektorfläche 35 erstreckt sich insbesondere nur teilweise über den aktiven Bereich 4.

Mit Vorteil wird gegenüber dem Bauelement in Figur 6 bei einem vorgegebenen Winkel α die Bauhöhe des Bauelements - also die Abmessung des Bauelements von den Anschlussflächen des Bauelements bis zu der den Anschlussflächen abgewandten Seite des Bauelements - verringert.

Auch mittels einer Reflektorfläche 35, die sich nur teilweise über den aktiven Bereich erstreckt, kann bereits effizient Strahlung in Richtung der Auskoppelflächen 19 gelenkt werden.

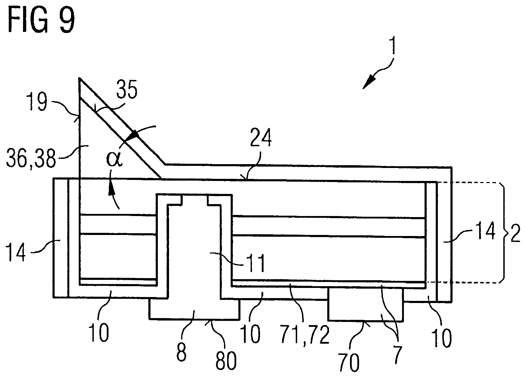

Figur 9 zeigt ein weiteres Ausführungsbeispiel eines optoelektronischen Bauelements 1 anhand einer schematischen Schnittansicht. Dieses Bauelement entspricht im wesentlichen den im Zusammenhang mit in den Figuren 6 und 8 beschriebenen Bauelementen. Ähnlich wie bei dem in Figur 8 gezeigten Bauelement überdeckt die Reflektorfläche 35 den aktiven Bereich nur teilweise. Im Unterschied zu Figur 8 ist ein Teilbereich der dem Auskoppelfenster 36 zugewandten Oberfläche 24 des Halbleiterkörpers frei von dem Auskoppelfenster. Diese freigelegte Oberfläche 24 ist vorzugsweise mit der Spiegelschicht 14 versehen. Zweckmäßigerweise ist die Spiegelschicht 14 seitens dieser Oberfläche unmittelbar auf den Halbleiterkörper oder auf ein auf den Halbleiterkörper aufgebrachtes Isolationsmaterial aufgebracht. Auch die Reflektorfläche 35 ist mit der Spiegelschicht 14 versehen. Ebenso wie im Falle des abgeflachten Bereichs 37 in Figur 8 kann durch ein lateral verkleinertes, vorzugsweise keil- oder kegelförmiges, Auskoppelfenster 36, welches sich nur über einen Teilbereich des aktiven Bereichs erstreckt, bei einem vorgegebenen Winkel α, z. B. 45°, eine Verringerung der Bauhöhe des Bauelements erzielt werden.

Das Auskoppelfenster und/oder die Auskoppelfläche kann entlang einer Querabmessung des Halbleiterkörpers, z.B. der Breite des Halbleiterkörpers 2, und/oder entlang einer Längsabmessung des Halbleiterkörpers 2, z.B. der Länge des Halbleiterkörpers, eine geringere Ausdehnung als der Halbleiterkörper aufweisen. Durch derart kleine Abmessungen kann beispielsweise ein Punktstrahler ausgebildet werden. Das Auskoppelfenster 36 kann als gesondertes Fenster auf den Halbleiterkörper, der vorzugsweise vom Träger 3 beziehungsweise der Trägerschicht 300 befreit ist, aufgebracht werden, oder als Trägerstück 38, also aus dem Träger 3 gefertigtes Stück ausgebildet, sein. Das Auskoppelfenster 36 wird vorzugsweise im Verbund ausgebildet. Über die Verspiegelung der dem Auskoppelfenster zugewandten Oberfläche des Halbleiterkörpers kann Strahlung trotz des kleinen Auskoppelfensters zu der Auskoppelfläche geführt werden, so dass eine hohe spezifische Ausstrahlung erzielt werden kann.

Die Erfindung ist nicht durch die Beschreibung anhand der Ausführungsbeispiele beschränkt.

## Patentansprüche

1. Optoelektronisches Bauelement (1) mit einem Halbleiterkörper (2), der einen zur Strahlungserzeugung geeigneten aktiven Bereich (4) aufweist, und mit zwei auf dem Halbleiterkörper angeordneten elektrischen Kontakten (7, 8), wobei
- die Kontakte elektrisch leitend mit dem aktiven Bereich verbunden sind,
- die Kontakte jeweils eine vom Halbleiterkörper abgewandte Anschlussfläche (70, 80) aufweisen,
- die Anschlussflächen auf einer gemeinsamen Anschlussseite des Bauelements angeordnet sind,
- eine von der Anschlussseite verschiedene Seite des Bauelements verspiegelt ist,
- das Bauelement (1) als seitlich emittierendes Bauelement ausgebildet ist,
- sich einer der Kontakte (7) bereichsweise zwischen dem Halbleiterkörper (2) und der Anschlussfläche (80) des anderen Kontaktes (8) erstreckt, - die Kontakte (7, 8) anschlussseitig elektrisch voneinander isoliert sind, und
- die Kontakte (7, 8) auf der Anschlussseite durch eine Isolationsschicht elektrisch voneinander getrennt sind.

2. Bauelement nach Anspruch 1,
bei dem die Verspiegelung eine elektrisch leitfähige Spiegelschicht und eine dielektrische Spiegelschicht aufweist.

3. Bauelement nach einem der vorhergehenden Ansprüche,
bei dem eine Auskoppelfläche (19) des Bauelements (1) Erhebungen und Vertiefungen (191) aufweist.

4. Bauelement nach mindestens einem der vorhergehenden Ansprüche, bei dem eine das Bauelement in einer lateralen Haupterstreckungsrichtung des aktiven Bereichs begrenzende Seitenfläche des Bauelements verspiegelt ist.

5. Bauelement nach mindestens einem der vorhergehenden Ansprüche,
bei dem sich eine verspiegelte Fläche (35) des Bauelements, die schräg zum aktiven Bereich (4) verläuft, über den aktiven Bereich erstreckt.

6. Bauelement nach mindestens einem der vorhergehenden Ansprüche,
das als oberflächenmontierbares Bauelement ausgeführt ist.

7. Verfahren zur Herstellung einer Mehrzahl von optoelektronischen Bauelementen (1) mit den Schritten:
- Bereitstellen eines Verbundelements (30) mit einer Trägerschicht (300) und einer Mehrzahl von auf der Trägerschicht angeordneten Halbleiterkörpern (2), die jeweils einen zur Strahlungserzeugung geeigneten aktiven Bereich (4) aufweisen;
- Aufbringen einer Spiegelschicht (140, 141) auf das Verbundelement,
- Vereinzeln des Verbundelements in eine Mehrzahl von optoelektronischen Bauelementen gemäß einem der vorhergehenden Ansprüche, die jeweils eine Auskoppelfläche (19) und eine das Bauelement begrenzende, von der Auskoppelfläche verschiedene und mit der Spiegelschicht versehene verspiegelte Seitenfläche (15, 22, 17) aufweisen.

8. Verfahren nach Anspruch 7,
bei dem das Verbundelement (30) vor dem Aufbringen der Spiegelschicht (140) bereichsweise mit einer Schutzschicht (32, 34) versehen wird und die Schutzschicht (32, 34) nach dem Aufbringen der Spiegelschicht entfernt wird.

9. Verfahren nach Anspruch 7 oder 8,
bei dem eine für das Ausbilden der Auskoppelfläche (19) vorgesehene Fläche des Verbundelements (30) zunächst verspiegelt wird, und die Spiegelschicht (140, 141) für das Ausbilden der Auskoppelfläche zumindest bereichsweise entfernt wird.

10. Verfahren nach Anspruch 9,
bei dem die für das Ausbilden der Auskoppelfläche vorgesehene Fläche des Verbundelements (30) mit der Schutzschicht (34) versehen wird, die Schutzschicht verspiegelt wird und die verspiegelte Schutzschicht nachfolgend entfernt wird.

11. Verfahren nach mindestens einem der Ansprüche 7 bis 9,
bei dem eine für das Ausbilden der Auskoppelfläche (19) vorgesehene Seite des Verbundelements (30) beim Aufbringen der Spiegelschicht abgeschattet ist.

12. Verfahren nach Anspruch 7 oder 8,
bei dem die Auskoppelfläche (19) eines Bauelements (1) beim Vereinzeln des Verbundelements geschaffen wird.

13. Verfahren nach Anspruch 12,
bei dem in der Auskoppelfläche (19) beim Vereinzeln des Verbundelements (30) Vertiefungen (191) ausgebildet werden.

14. Verfahren nach mindestens einem der Ansprüche 7 bis 13,
bei dem die Spiegelschicht (140, 141) beim Vereinzeln durchtrennt wird.

15. Verfahren nach mindestens einem der Ansprüche 7 bis 14, bei dem die Spiegelschicht (140) auf dem Verbundelement (30) abgeschieden wird.

## Claims

1. Optoelectronic component (1) comprising a semiconductor body (2), which has an active region (4) suitable for generating radiation, and comprising two electrical contacts (7, 8) arranged on the semiconductor body, wherein.
- the contacts are electrically conductively connected to the active region,
- the contacts in each case have a connection area (70, 80) facing away from the semiconductor body,
- the connection areas are arranged on a common connection side of the component,
- a side of the component which is different from the connection side is reflectively coated,
- the component (1) is embodied as a laterally emitting component,
- one of the contacts (7) extends regionally between the semiconductor body (2) and the connection area (80) of the other contact (8),
- the contacts (7, 8) are electrically insulated from one another on the connection side, and
- the contacts (7, 8) on the connection side are electrically isolated from one another by an insulation layer.

2. Component according to Claim 1,
wherein the reflective coating has an electrically conductive mirror layer and a dielectric mirror layer.

3. Component according to either of the preceding claims,
wherein a coupling-out area (19) of the component (1) has elevations and depressions (191).

4. Component according to at least one of the preceding claims,
wherein a side surface of the component which delimits the component in a lateral main extension direction of the active region is reflectively coated.

5. Component according to at least one of the preceding claims,
wherein a reflectively coated area (35) of the component, which area runs obliquely with respect to the active region (4), extends over the active region.

6. Component according to at least one of the preceding claims,
which is embodied as a surface-mountable component.

7. Method for producing a plurality of optoelectronic components (1) comprising the following steps:
- providing a composite element (30) comprising a carrier layer (300) and a plurality of semiconductor bodies (2) which are arranged on the carrier layer and which in each case have an active region (4) suitable for generating radiation;
- applying a mirror layer (140, 141) to the composite element,
- singulating the composite element into a plurality of optoelectronic components according to any of the preceding claims, which in each case have a coupling-out area (19) and a reflectively coated side surface (15, 22, 17) which delimits the component, is different from the coupling-out area and is provided with the mirror layer.

8. Method according to Claim 7,
wherein the composite element (30) is provided regionally with a protective layer (32, 34) before the mirror layer (140) is applied, and the protective layer (32, 34) is removed after the mirror layer has been applied.

9. Method according to Claim 7 or 8,
wherein an area of the composite element (30) which is provided for forming the coupling-out area (19) is firstly reflectively coated, and the mirror layer (140, 141) is removed at least regionally for forming the coupling-out area.

10. Method according to Claim 9,
wherein the area of the composite element (30) which is provided for forming the coupling-out area is provided with the protective layer (34), the protective layer is reflectively coated, and the reflectively coated protective layer is subsequently removed.

11. Method according to at least one of Claims 7 to 9,
wherein a side of the composite element (30) which is provided for forming the coupling-out area (19) is shaded during the process of applying the mirror layer.

12. Method according to Claim 7 or 8,
wherein the coupling-out area (19) of a component (1) is created during the process of singulating the composite element.

13. Method according to Claim 12,
wherein depressions (191) are formed in the coupling-out area (19) during the process of singulating the composite element (30).

14. Method according to at least one of Claims 7 to 13,
wherein the mirror layer (140, 141) is severed during singulating.

15. Method according to at least one of Claims 7 to 14,
wherein the mirror layer (140) is deposited on the composite element (30).

## Revendications

1. Composant optoélectronique (1) avec un corps semi-conducteur (2) comportant une zone active (4) adaptée à la production d'un rayonnement et avec deux contacts électriques (7, 8) disposés sur le corps semi-conducteur ;
- les contacts étant reliés de façon électriquement conductrice à la zone active ;
- les contacts comportant respectivement une surface de raccordement (70, 80) située à l'opposé du corps semi-conducteur ;
- les surfaces de raccordement étant disposées sur un côté de raccordement commun du composant ;
- un côté du composant, différent du côté de raccordement, étant réfléchi ;
- le composant (1) étant réalisé sous la forme d'un composant émettant en côté ;
- un des contacts (7) s'étendant en partie entre le corps semi-conducteur (2) et la surface de raccordement (80) de l'autre contact (8) ;
- les contacts (7, 8) étant isolés les uns des autres sur le plan électrique sur le côté de raccordement ; et
- les contacts (7, 8) étant séparés les uns des autres sur le plan électrique par une couche isolante sur le côté de raccordement.

2. Composant selon la revendication 1, dans lequel le revêtement en miroirs comporte une couche réfléchissante et une couche réfléchissante diélectrique.

3. Composant selon l'une quelconque des revendications précédentes, dans lequel une surface de découplage (19) du composant (1) comporte des éminences et des renfoncements (191).

4. Composant selon au moins l'une quelconque des revendications précédentes, dans lequel une surface latérale du composant délimitant le composant dans une direction d'extension principale latérale de la zone active est réfléchie.

5. Composant selon au moins l'une quelconque des revendications précédentes, dans lequel une surface réfléchie (35) du composant s'étendant de façon oblique par rapport à la zone active (4) s'étend sur l'ensemble de la zone active.

6. Composant selon au moins l'une quelconque des revendications précédentes réalisé à la façon d'un composant montable en surface.

7. Procédé de fabrication d'une pluralité de composants optoélectroniques (1) avec les étapes suivantes :
- mise à disposition d'un élément composite (30) avec une couche de support (300) et une pluralité de corps semi-conducteurs (2) disposés sur la couche de support et comportant respectivement une zone active (4) adaptée à la production d'un rayonnement ;
- application d'une couche réfléchissante (140, 141) sur l'élément composite ;
- séparation de l'élément composite dans une pluralité de composants optoélectroniques selon l'une quelconque des revendications précédentes comportant respectivement une surface de découplage (19) et une surface latérale (15, 22, 17) réfléchie délimitant le composant, différente de la surface de découplage et pourvue de la couche réfléchissante.

8. Procédé selon la revendication 7, dans lequel l'élément composite (30) est pourvu en partie d'une couche de protection (32, 34) avant l'application de la couche réfléchissante (140) et dans lequel la couche de protection (32, 34) est supprimée après l'application de la couche réfléchissante.

9. Procédé selon la revendication 7 ou 8, dans lequel une surface de l'élément composite (30) prévue pour former la surface de découplage (19) est d'abord réfléchie et dans lequel la couche réfléchissante (140, 141) servant à la formation de la surface de découplage est au moins en partie supprimée.

10. Procédé selon la revendication 9, dans lequel la surface de l'élément composite (30) prévue pour former la surface de découplage est pourvue de la couche de protection (34), la couche de protection étant réfléchie et la couche de protection réfléchie étant ensuite supprimée.

11. Procédé selon au moins l'une quelconque des revendications 7 à 9, dans lequel un côté de l'élément composite (30) prévu pour former la surface de découplage (19) est dégradée lors de l'application de la couche réfléchissante.

12. Procédé selon la revendication 7 ou 8, dans lequel la surface de découplage (19) d'un composant (1) est créée lors de la séparation de l'élément composite.

13. Procédé selon la revendication 12, dans lequel des renfoncements (191) sont réalisés dans la surface de découplage (19) lors de la séparation de l'élément composite (30).

14. Procédé selon au moins l'une quelconque des revendications 7 à 13, dans lequel la couche réfléchissante (140, 141) est sectionnée lors de la séparation.

15. Procédé selon au moins l'une quelconque des revendications 7 à 14, dans lequel la couche réfléchissante (140) est isolée sur l'élément composite (30).
